(19) Europäisches Patentamt
European Patent Office
Office européen des brevets

(11) **EP 2 579 532 A2**

(12) **EUROPEAN PATENT APPLICATION**
published in accordance with Art. 153(4) EPC

(43) Date of publication:
**10.04.2013 Bulletin 2013/15**

(51) Int Cl.:
*H04L 27/26* (2006.01)    *H04B 7/26* (2006.01)
*H04B 7/04* (2006.01)    *H03M 13/00* (2006.01)

(21) Application number: **11790017.5**

(22) Date of filing: **01.06.2011**

(86) International application number:
**PCT/KR2011/004005**

(87) International publication number:
**WO 2011/152659 (08.12.2011 Gazette 2011/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.06.2010 US 355928 P**
**10.06.2010 US 353608 P**
**09.06.2010 US 352829 P**
**01.06.2010 US 350034 P**

(71) Applicant: **LG Electronics Inc.**
**Yeongdeungpo-gu**
**Seoul 150-721 (KR)**

(72) Inventors:
• **JANG, Jiwoong**
**Anyang-si**
**Gyeonggi-do 431-080 (KR)**

• **CHUNG, Jaehoon**
**Anyang-si**
**Gyeonggi-do 431-080 (KR)**
• **HAN, Seunghee**
**Anyang-si**
**Gyeonggi-do 431-080 (KR)**
• **LEE, Hyunwoo**
**Anyang-si**
**Gyeonggi-do 431-080 (KR)**

(74) Representative: **Cabinet Plasseraud**
**52, rue de la Victoire**
**75440 Paris Cedex 09 (FR)**

(54) **METHOD FOR TRANSMITTING CONTROL INFORMATION IN WIRELESS COMMUNICATION SYSTEM, AND APPARATUS FOR SAME**

(57) The present invention relates to a method for transmitting control information in a wireless communication system, and an apparatus for the same. According to one aspect of the present invention, a method for allowing a terminal to transmit channel quality information (CQI) data using a code matrix to which a Reed-Muller coding scheme is applied in a wireless communication system comprises the steps of: generating a first code by applying a cyclic shift by a preset number of positions in a column direction with respect to the rows of the code matrix; coding the channel quality information data by applying the generated first code matrix to the CQI data; and transmitting the coded channel quality information data.

FIG. 1

**Description**

[Technical Field]

The present invention relates to a wireless communication system, and more particularly to a method and apparatus for transmitting control information in a wireless communication system.

[Background Art]

In a mobile communication system, a user equipment (UE) may receive information from a base station (BS) via a downlink, and may transmit information via an uplink. The information that is transmitted and received to and from the UE includes data and a variety of control information. A variety of physical channels are used according to categories of transmission (Tx) and reception (Rx) information of the UE.

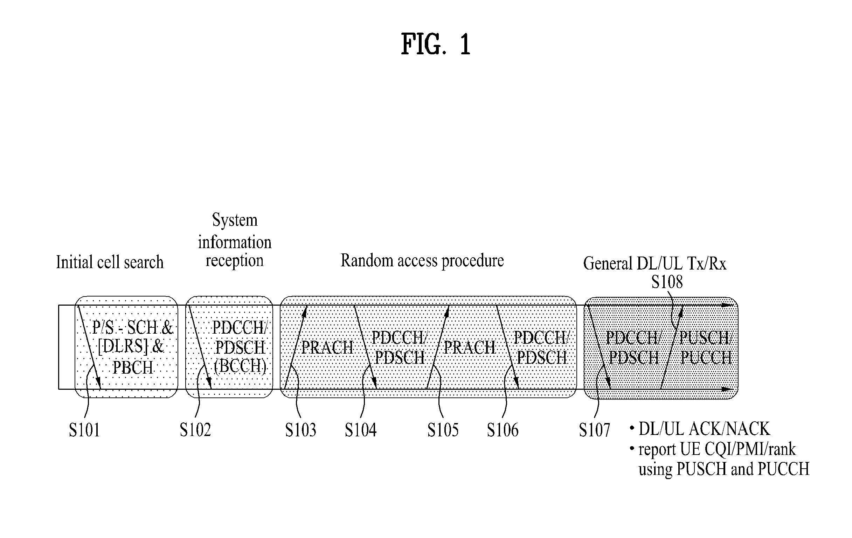

FIG. 1 is a conceptual diagram illustrating physical channels for use in a 3rd Generation Partnership Project (3GPP) system, as an exemplary mobile communication system, and a general method for transmitting a signal using the physical channels.

Referring to FIG. 1, when powered on or when entering a new cell, a UE performs initial cell search in step S101. The initial cell search involves synchronization with a BS. Specifically, the UE synchronizes with the BS and acquires a cell identifier (ID) and other information by receiving a Primary Synchronization CHannel (P-SCH) and a Secondary Synchronization CHannel (S-SCH) from the BS. Then the UE may acquire information broadcast in the cell by receiving a Physical Broadcast CHannel (PBCH) from the BS. During the initial cell search, the UE may monitor a downlink channel status by receiving a downlink Reference Signal (DL RS).

After initial cell search, the UE may acquire more specific system information by receiving a Physical Downlink Control CHannel (PDCCH) and receiving a Physical Downlink Shared CHannel (PDSCH) based on information of the PDCCH in step S102.

Meanwhile, in order to allow the UE not yet connected to the BS to completely access the BS, the UE may perform random access to the BS in steps S103 to S106. For random access, the UE may transmit a specific sequence serving as a preamble to the BS on a Physical Random Access CHannel (PRACH) in step S103 and receive a response message for the random access on a PDCCH and a PDSCH corresponding to the PDCCH in step S104. In the case of contention-based random access other than handover, the UE may transmit an additional PRACH in step S105, and receive a PDCCH and a PDSCH corresponding to the PDCCH in step S106 in such a manner that the UE can perform a contention resolution procedure.

After the above random access procedure, the UE may receive a PDCCH/PDSCH (S107) and transmit a Physical Uplink Shared CHannel (PUSCH)/Physical Uplink Control CHannel (PUCCH) (S108) in a general uplink/downlink signal transmission procedure.

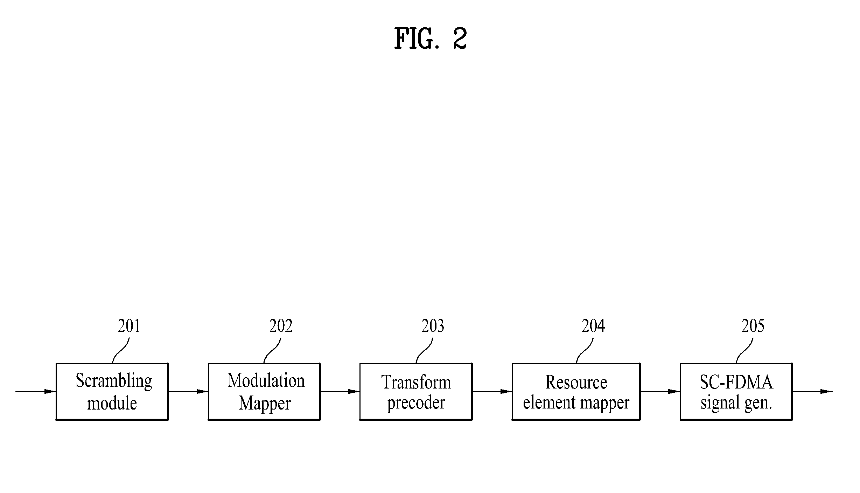

FIG. 2 is a conceptual diagram illustrating a signal processing method for transmitting an uplink signal by a user equipment (UE).

Referring to FIG. 2, the scrambling module 201 may scramble a transmission signal in order to transmit the uplink signal. The scrambled signal is input to the modulation mapper 202, such that the modulation mapper 202 modulates the scrambled signal to complex symbols in Binary Phase Shift Keying (BPSK), Quadrature Phase Shift Keying (QPSK), or 16-ary Quadrature Amplitude Modulation (16QAM) according to the type of the transmission signal and/or a channel status. A transform precoder 203 processes the complex symbols and a resource element mapper 204 may map the processed complex symbols to time-frequency resource elements, for actual transmission. The mapped signal may be transmitted to the BS through an antenna after being processed in a Single Carrier-Frequency Division Multiple Access (SC-FDMA) signal generator 205.

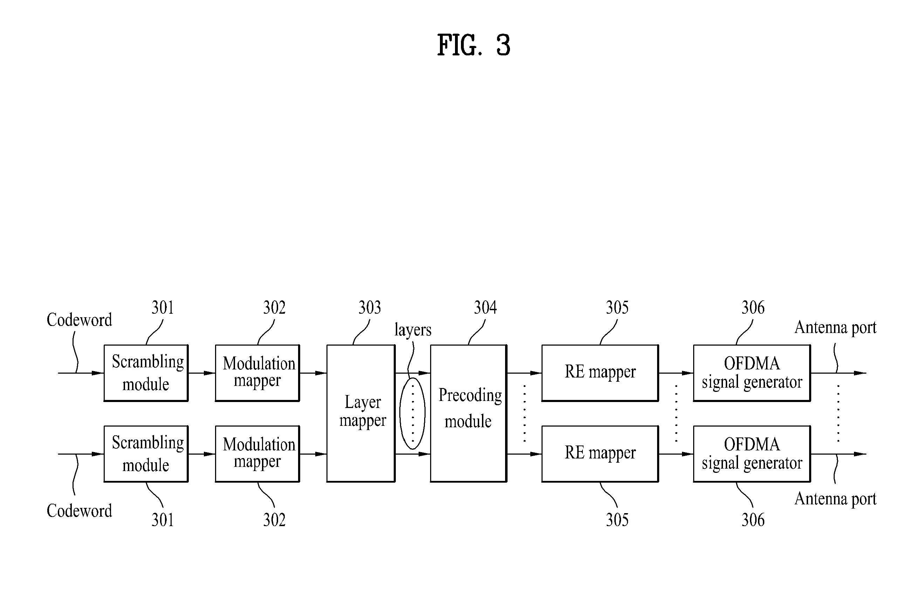

FIG. 3 is a conceptual diagram illustrating a signal processing method for transmitting a downlink signal by a base station (BS).

Referring to FIG. 3, the BS can transmit one or more codewords via downlink in a 3GPP LTE system. Codewords may be processed as complex symbols by the scrambling module 301 and the modulation mapper 302 in the same manner as in the uplink operation shown in FIG. 2. Thereafter, the complex symbols are mapped to a plurality of layers by the layer mapper 303, and each layer is multiplied by a predetermined precoding matrix and is then allocated to each transmission antenna by the precoder 304. The processed transmission signals of individual antennas are mapped to time-frequency resource elements (REs) to be used for data transmission by the RE mapper 305. Thereafter, the mapped result may be transmitted via each antenna after passing through the OFDMA signal generator 306.

In the case where a UE for use in a mobile communication system transmits an uplink signal, a Peak to Average Power Ratio (PAPR) may become more serious than in the case where the BS transmits a downlink signal. Thus, as described in FIGS. 2 and 3, the SC-FDMA scheme is used for uplink signal transmission in a different way from the OFDMA scheme used for downlink signal transmission.

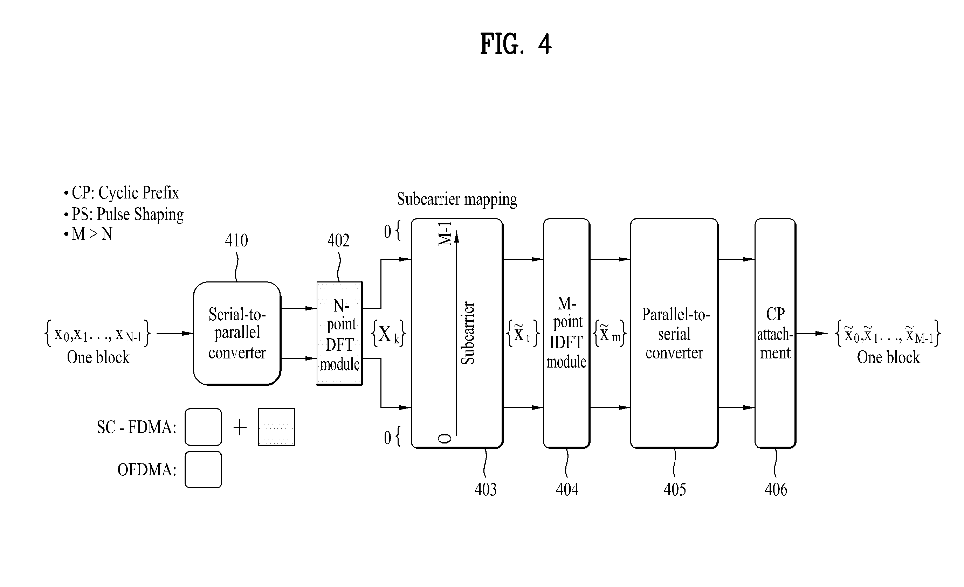

FIG. 4 is a conceptual diagram illustrating an SC-FDMA scheme and an OFDMA scheme for transmitting uplink signals in a mobile communication system according to embodiments of the present invention.

Referring to FIG. 4, not only a UE for uplink signal transmission but also a BS for downlink signal transmission includes a Serial-to-Parallel converter 401, a subcarrier mapper 403, an M-point IDFT module 404 and a Cyclic Prefix (CP) attachment module 406.

However, a UE for transmitting a signal using the SC-FDMA scheme further includes a Parallel-to-Serial converter 405 and an N-point DFT module 402. The N-point DFT module 402 compensates for a predetermined part of the IDFT processing influence of the M-point IDFT module 404 so that a transmission signal can have single carrier characteristics (i.e., single-carrier properties).

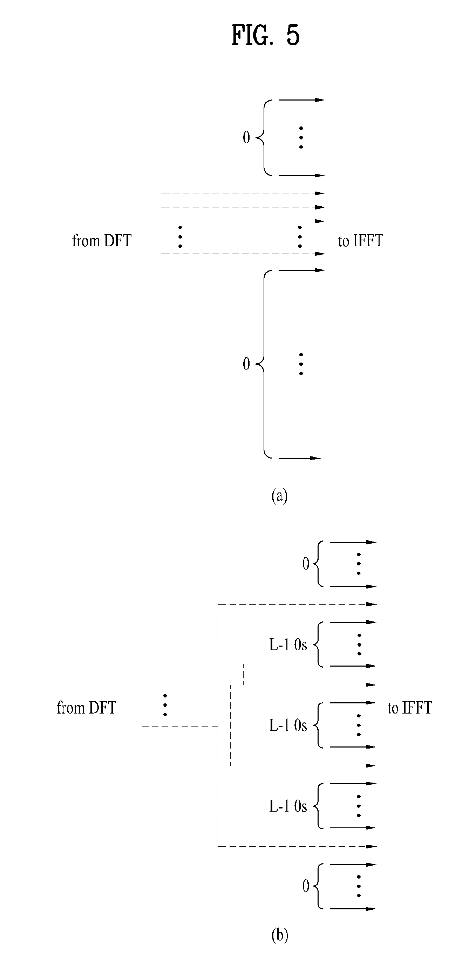

FIG. 5 illustrates a signal mapping scheme in the frequency domain for satisfying the single carrier properties. FIG. 5 (a) shows a localized mapping scheme and FIG. 5 (b) shows a distributed mapping scheme. The localized mapping scheme has been defined in the current 3GPP LTE system.

A clustered SC-FDMA scheme which is a modified form of the SC-FDMA scheme is described as follows. In the clustered SC-FDMA scheme, DFT process output samples are divided into sub-groups in a subcarrier mapping procedure sequentially performed between a DFT process and an IFFT process. Then the sub-groups are mapped to non-contiguous subcarrier regions by the IFFT sample input unit. If necessary, the clustered SC-FDMA scheme may further include a filtering process and a cyclic extension process.

In this case, each sub-group may be referred to as a cluster, and the term "cyclic extension" means that a guard interval longer than a maximum delay spread is inserted between contiguous symbols so as to prevent Inter-Symbol Interference (ISI) from being generated when each symbol of subcarriers is transmitted over a multi-path channel.

[Disclosure]

[Technical Problem]

Accordingly, the present invention is directed to a method and apparatus for transmitting control information in a wireless communication system that substantially obviate one or more problems due to limitations and disadvantages of the related art.

It will be appreciated by persons skilled in the art that the objects that can be achieved through the present invention are not limited to what has been particularly described hereinabove and the above and other objects that the present invention can achieve will be more clearly understood from the following detailed description taken in conjunction with the accompanying drawings.

[Technical Solution]

The object of the present invention can be achieved by providing a method for allowing a user equipment (UE) to transmit channel quality information (CQI) data using a code matrix to which a Reed-Muller (RM) coding scheme is applied in a wireless communication system, the method comprising: generating a first code matrix by cyclically shifting a row of the code matrix by a predetermined column-directional size; encoding the CQI data by applying the first code matrix to the CQI data; and transmitting the encoded CQI data.

The method may further or alternatively include, if a bit size of the CQI data is equal to or exceeds a predetermined number, generating the first code matrix.

Additionally or alternatively, if the number of rows of the code matrix is set to 20, the predetermined number may be set to 6.

Additionally or alternatively, if the number of rows of the code matrix is set to 20, the predetermined column-directional size may be set to any one of 1 to 9.

In another aspect of the present invention, a method for allowing a user equipment (UE) to transmit channel quality information (CQI) data using at least one code matrix to which a Reed-Muller (RM) coding scheme is applied in a wireless communication system includes: generating a second code matrix by shifting a first row corresponding to at least one row of the code matrix to a predetermined position; encoding the CQI data by applying the second code matrix to the CQI data; and transmitting the encoded CQI data.

Additionally or alternatively, the predetermined position may correspond to the last column of the code matrix.

In another aspect of the present invention, a user equipment (UE) for transmitting channel quality information (CQI) data using a code matrix to which a Reed-Muller (RM) coding scheme is applied in a wireless communication system includes: a processor configured to generate a first code matrix by cyclically shifting a row of the code matrix by a predetermined column-directional size, and encode the CQI data by applying the first code matrix to the CQI data; and a transmission module configured to transmit the encoded CQI data.

Additionally or alternatively, if a bit size of the CQI data is equal to or exceeds a predetermined number, the processor may generate the first code matrix.

Additionally or alternatively, if the number of rows of the code matrix is set to 20, the predetermined number may be set to 6.

Additionally or alternatively, if the number of rows of the code matrix is set to 20, the predetermined column-directional size may be set to any one of 1 to 9.

In another aspect of the present invention, a user equipment (UE) for transmitting channel quality information (CQI) data using at least one code matrix to which a Reed-Muller (RM) coding scheme is applied in a wireless communication system includes: a processor configured to generate a second code matrix by shifting a first row corresponding to at least one row of the code matrix to a predetermined position, and encoding the CQI data by applying the second code matrix to the CQI data; and a transmission module configured to transmit the encoded CQI data.

Additionally or alternatively, the predetermined position may correspond to the last column of the code matrix.

[Advantageous Effects]

Exemplary embodiments of the present invention have the following effects. In a wireless communication system, a transmitter can effectively encode control information according to the present invention.

It will be appreciated by persons skilled in the art that the effects that can be achieved through the present invention are not limited to what has been particularly described hereinabove and other advantages of the present invention will be more clearly understood from the following detailed description taken in conjunction with the accompanying drawings.

[Description of Drawings]

The accompanying drawings, which are included to provide a further understanding of the invention, illustrate embodiments of the invention and together with the description serve to explain the principle of the invention.

FIG. 1 is a conceptual diagram illustrating physical channels used in a 3GPP LTE system acting as an exemplary mobile communication system and a general method for transmitting a signal using the physical channels.

FIG. 2 is a conceptual diagram illustrating a method for processing an uplink signal by a user equipment (UE).

FIG. 3 is a conceptual diagram illustrating a method for processing a downlink signal by a base station (BS).

FIG. 4 is a conceptual diagram illustrating an SC-FDMA scheme for transmitting uplink signals and an OFDMA scheme for transmitting downlink signals in a mobile communication system according to embodiments of the present invention.

FIG. 5 is a conceptual diagram illustrating a signal mapping scheme in a frequency domain so as to satisfy single carrier characteristics.

FIG. 6 is a conceptual diagram illustrating the signal processing for mapping DFT process output samples to a single carrier in the clustered SC-FDMA scheme according to an embodiment of the present invention.

FIGS. 7 and 8 show the signal processing in which DFT process output samples are mapped to multiple carriers in the clustered SC-FDMA scheme according to an embodiment of the present invention.

FIG. 9 is a conceptual diagram illustrating signal processing for use in the segmented SC-FDMA system.

FIG. 10 is a conceptual diagram illustrating a signal processing procedure for transmitting a reference signal (RS) on uplink.

FIG. 11 shows a subframe structure for transmitting a reference signal (RS) in the case of a normal CP.

FIG. 12 shows a subframe structure for transmitting a reference signal (RS) in the case of an extended CP.

FIG. 13 is a block diagram illustrating signal processing of a transport channel of an uplink shared channel.

FIG. 14 is a conceptual diagram illustrating a method for mapping uplink data to a physical resource transmitting a control channel.

FIG. 15 is a flowchart illustrating a method for efficiently multiplexing data and a control channel on an uplink shared channel.

FIG. 16 is a block diagram illustrating a method for generating data and a transmission signal of a control channel.

FIG. 17 is a conceptual diagram illustrating a codeword-to-layer mapping method.

FIG. 18 shows exemplary performance resultant values using a code matrix generated by cyclically shifting a row by a predetermined column-directional size.

FIG. 19 is a block diagram illustrating a communication device according to embodiments of the present invention.

[Best Mode]

Reference will now be made in detail to the preferred embodiments of the present invention with reference to the accompanying drawings. The detailed description, which will be given below with reference to the accompanying drawings, is intended to explain exemplary embodiments of the present invention, rather than to show the only embodiments that can be implemented according to the invention. The following embodiments are implemented by applying technical characteristics of the present invention to a system configured to use a plurality of orthogonal subcarriers. For convenience of description, although the following embodiments of the present invention will hereinafter describe inventive technical characteristics on the basis of the 3GPP system, it should be noted that the following embodiments will be disclosed only for illustrative purposes and the scope and spirit of the present invention are not limited thereto and can be applied to other wireless communication systems.

Specific terms used in the exemplary embodiments of the present invention are provided to aid in understanding of the present invention. These specific terms may be replaced with other terms within the scope and spirit of the present invention.

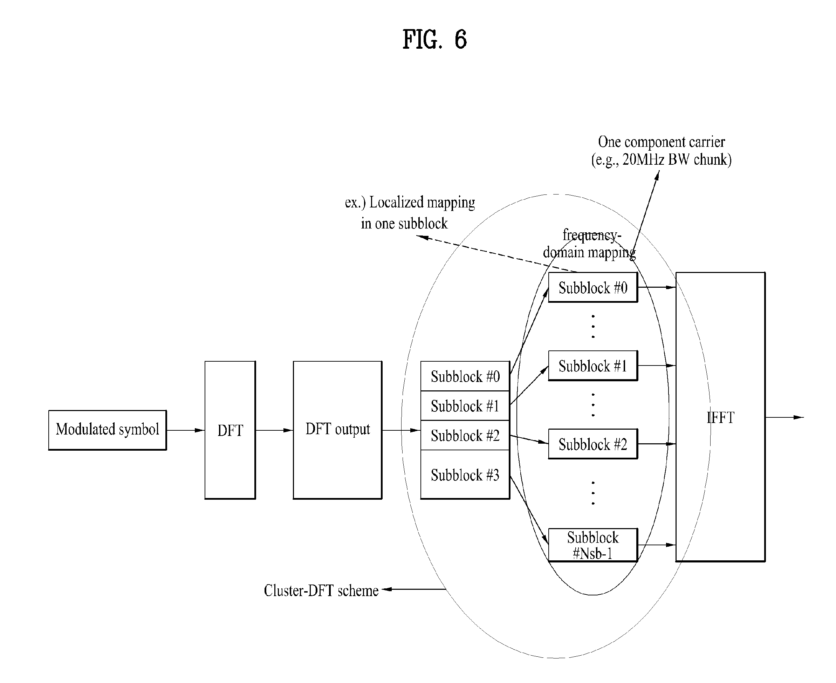

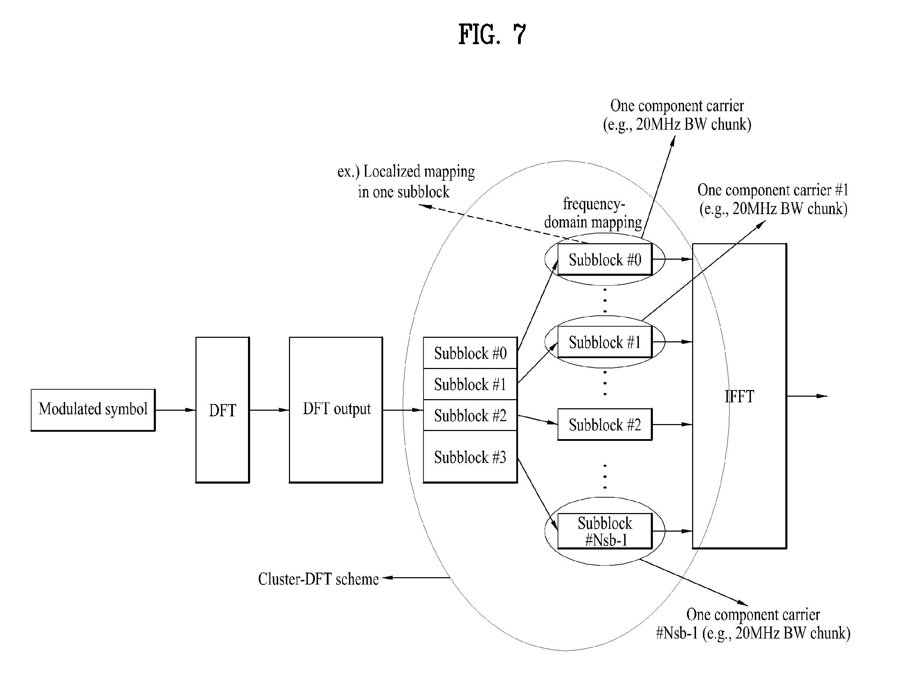

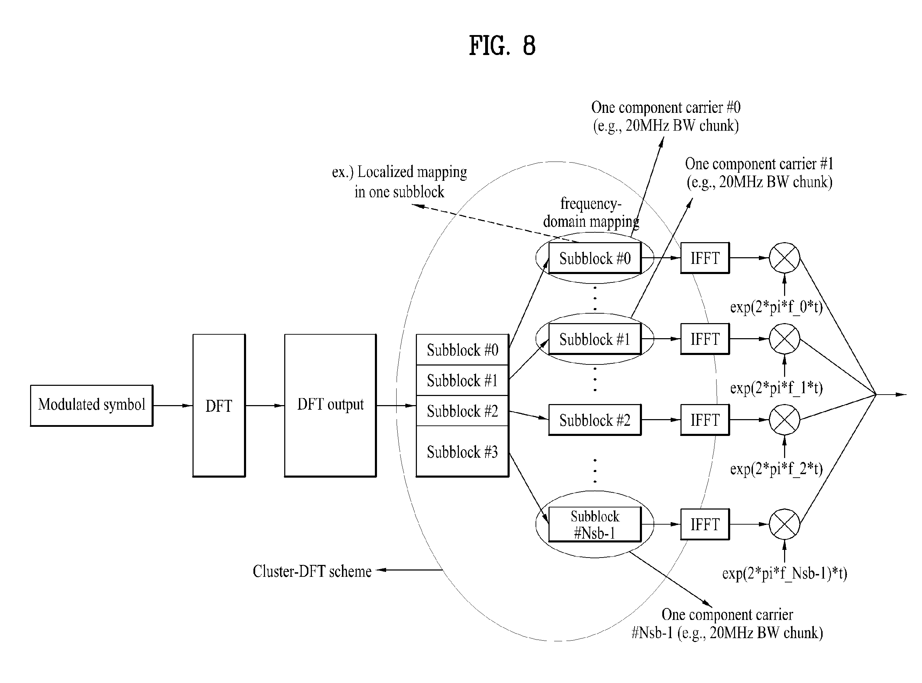

FIG. 6 shows signal processing in which DFT-process output samples are mapped to one carrier in the clustered SC-FDMA. FIGS. 7 and 8 show signal processing in which DFT process output samples are mapped to multiple carriers in a clustered SC-FDMA.

FIG. 6 shows an example of intra-carrier cluster SC-FDMA application. FIGS. 7 and 8 show examples of the inter-carrier clustered SC-FDMA application. FIG. 7 shows the example in which a signal is generated through a single IFFT block under the condition that component carriers are contiguously allocated to a frequency domain and the subcarrier spacing between contiguous component carriers is arranged. FIG. 8 shows another example in which a signal is generated through several IFFT blocks under the condition that component carriers are non-contiguously allocated to a frequency domain.

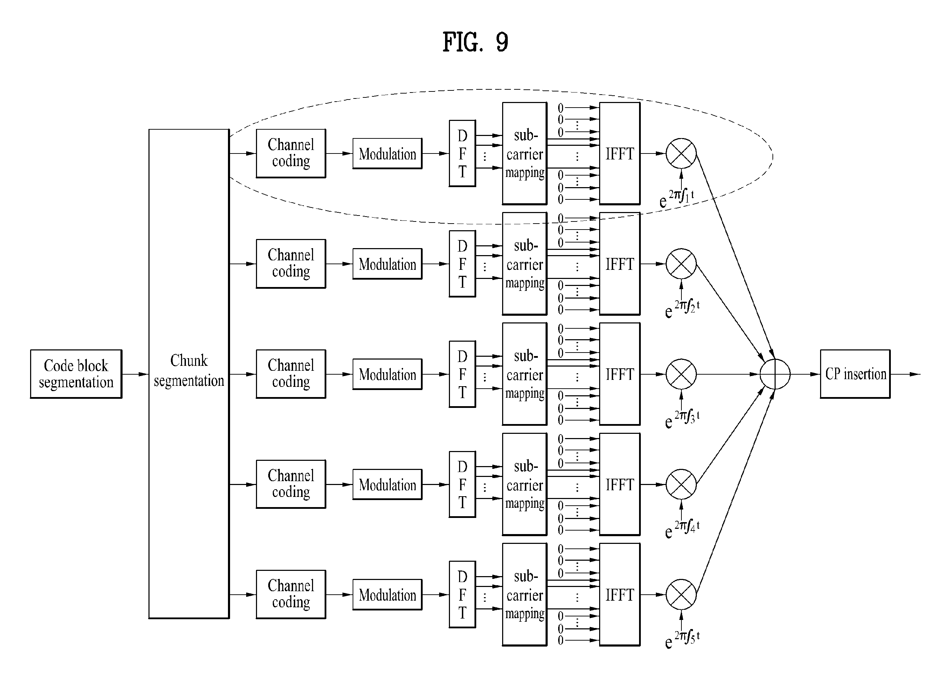

The segmented SC-FDMA to which the same number of IFFTs as an arbitrary number of DFTs is applied may be considered to be an extended version of the conventional SC-FDMA DFT spread and the IFFT frequency subcarrier mapping structure because the relationship between DFT and IFFT is one-to-one. If necessary, segmented SC-FDMA may also be represented by NxSC-FDMA or NxDFT-s-OFDMA. For convenience of description and better understanding of the present invention, the segmented SC-FDMA, NxSC-FDMA and NxDFT-s-OFDMA may be generically referred to as 'segment SC-FDMA'. FIG. 9 is a conceptual diagram illustrating signal processing for use in the segmented SC-FDMA system. Referring to FIG. 9, in order to reduce single carrier characteristics, the segment SC-FDMA groups all the time domain modulation symbols into N groups (N being an integer greater than 1), such that a DFT process is performed in units of a group.

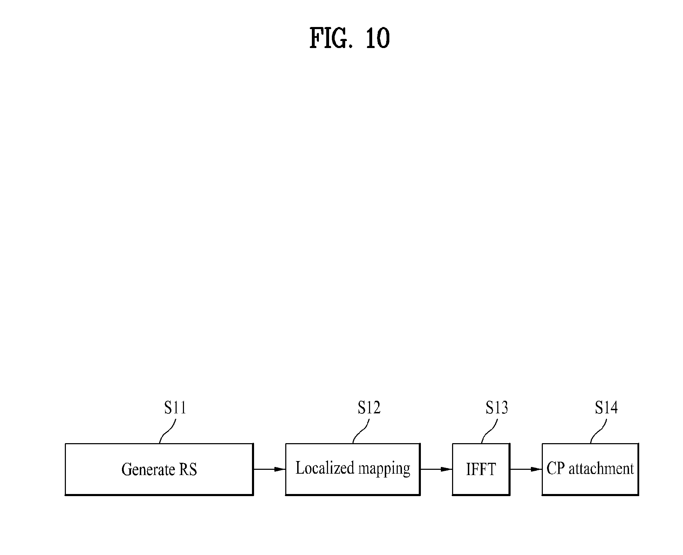

FIG. 10 is a conceptual diagram illustrating a signal processing procedure for transmitting a reference signal (RS) on uplink. Referring to FIG. 10, data is transformed into a time domain signal. The resultant signal is then transmitted after being subjected to frequency mapping and IFFT by a DFT precoder. On the other hand, an RS does not pass through the DFT precoder. More specifically, an RS sequence is directly generated in the frequency domain (S11) and is then transmitted after being sequentially subjected to a localized-mapping process (S12), an IFFT process (S13), and a CP attachment process (S14).

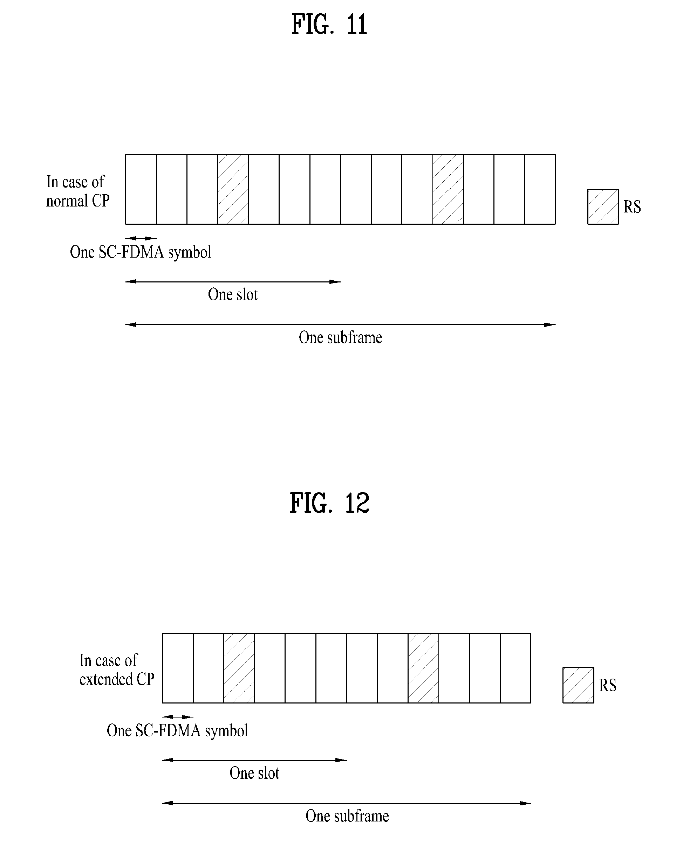

FIG. 11 shows a subframe structure for transmitting a reference signal (RS) in the case of a normal CP. FIG. 12 shows a subframe structure for transmitting a reference signal (RS) in the case of an extended CP. In the structure of FIG. 11, an RS is transmitted through fourth and eleventh OFDM symbols and, in the structure of FIG. 12, an RS is transmitted through third and ninth OFDM symbols.

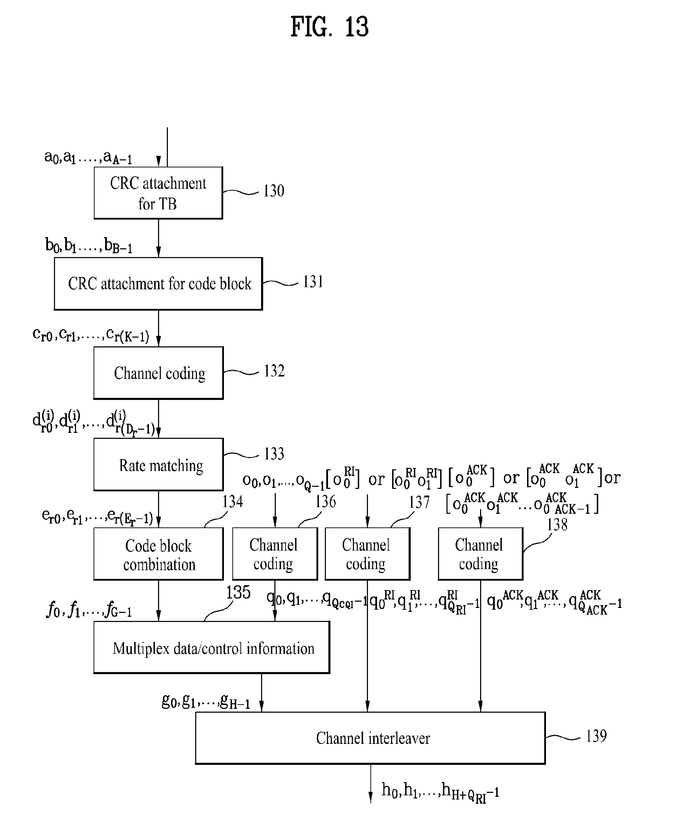

Meanwhile, a structure for processing an uplink shared channel serving as a transport channel will hereinafter be described in detail. FIG. 13 is a block diagram illustrating signal processing of a transport channel of an uplink shared channel. Referring to FIG. 13, according to data multiplexed with control information, a transport block (TB) cyclic redundancy check (CRC) to be transmitted on uplink is attached to the transport block (TB) (Step 130). The resultant TB is then divided into a plurality of code blocks (CBs) according to TB size, and CB CRC is attached to a plurality of CBs (Step 131). Thereafter, the CRC attachment resultant value is channel-encoded (Step 132). In addition, after channel-encoded data is rate-matched (Step 133), combination between CBs is carried out (Step S134). The combined CBs are multiplexed with CQI/PMI (Channel Quality Information / Precoding matrix Index) (Step 135).

CQI/PMI is channel-encoded separately from data (Step 136). The channel encoded CQI/PMI is multiplexed with data (Step S135).

In addition, Rank Indication (RI) is channel-encoded separately from data (Step 137).

ACK/NACK (Acknowledgement / Negative Acknowledgement) is channel-encoded separately from data, CQI/PMI and RI (Step 138). The multiplexed data, CQI/PMI, and separately channel-encoded RI and ACK/NACK are channel-interleaved, so that output signals are generated (Step 139).

A physical resource element (PRE) for both data and a control channel in the LTE uplink system will hereinafter be described in detail.

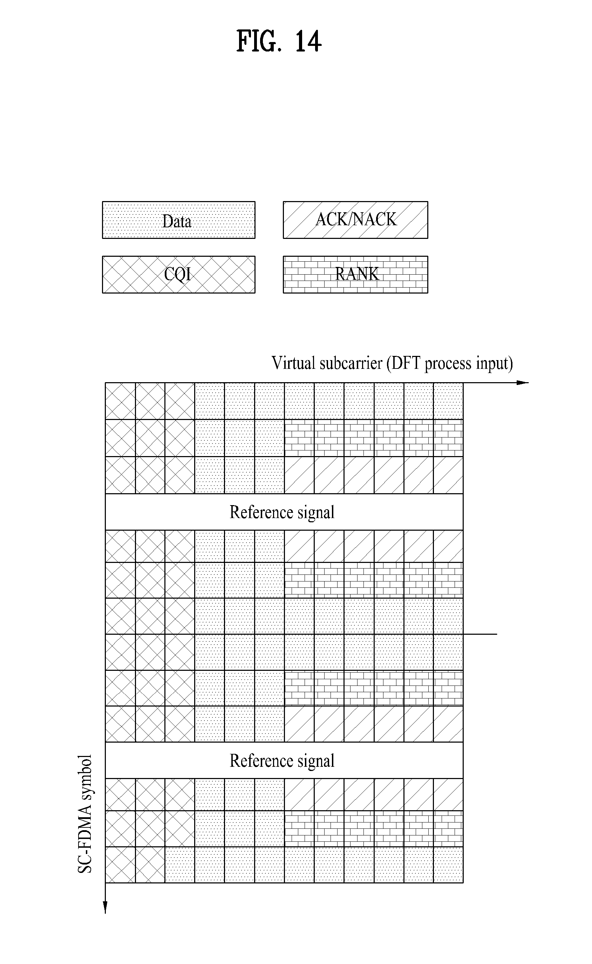

FIG. 14 is a conceptual diagram illustrating a method for mapping uplink data to a physical resource transmitting a control channel.

Referring to FIG. 14, CQI/PMI and data are mapped to RE according to a time-first scheme. The encoded ACK/NACK are punctured and inserted in the vicinity of a demodulation reference signal (DM RS) symbol. RI is mapped to an RE next to an RE where ACK/NACK is located. A resource for RI and ACK/NACK can occupy a maximum of 4 SC-FDMA symbols. When data and control information are simultaneously transmitted over an uplink shared channel, the order of mapping is RI → concatenation of CQI/PMI and data → ACK/NACK. That is, after RI is first mapped, concatenation between data and CQI/PMI is mapped to the remaining REs other than REs mapped to RI according to the time-first scheme. ACK/NACK simultaneously performs puncturing and mapping of concatenation of previously-mapped CQI/PMI and data.

As described above, since uplink control information (UCI) is multiplexed with data and CQI/PMI, single carrier characteristics can be satisfied, so that uplink transmission capable of maintaining low cubic metric (CM) can be achieved.

In a system (e.g., LTE Rel-10) evolved from the legacy system, at least one of the SC-FDMA transmission scheme and the clustered DFTs OFDMA scheme on each component carrier (CC) of each UE can be applied to uplink transmission, and can also be applied along with UL-MIMO transmission.

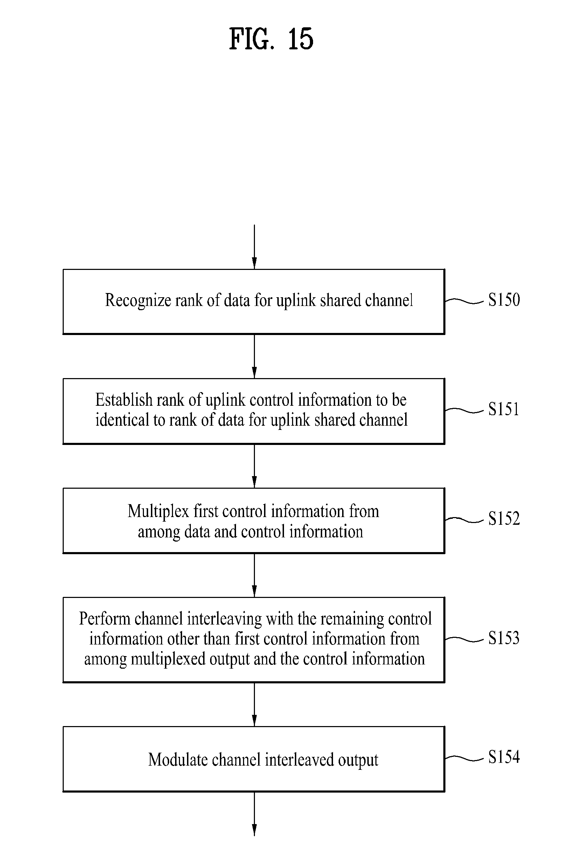

FIG. 15 is a flowchart illustrating a method for efficiently multiplexing data and a control channel on an uplink shared channel.

Referring to FIG. 15, a user equipment (UE) recognizes a rank of physical uplink shared channel (PUSCH) data (Step S150). Thereafter, the UE establishes a rank of an uplink control channel using the same rank as a rank of the data (Step S151). The control channel is uplink control information (UCI) such as CQI, ACK/NACK, RI, etc. In addition, the UE multiplexes data and control information (Step S152). Thereafter, after data and CQI are mapped according to the time-first scheme, RI is mapped to a predetermined RE, and ACK/NACK can be channel-interleaved in such a manner that REs located in the vicinity of DM-RS are punctured and mapped (Step S153).

Thereafter, data and a control channel can be QPSK-, 16QAM-, or 64QAM- modulated according to an MCS table (Step S154). In this case, the above-mentioned modulation step may be shifted to another position (for example, the modulation step may be shifted to any position located prior to multiplexing of data and a control channel). In addition, channel interleaving may be performed in units of a codeword or layer.

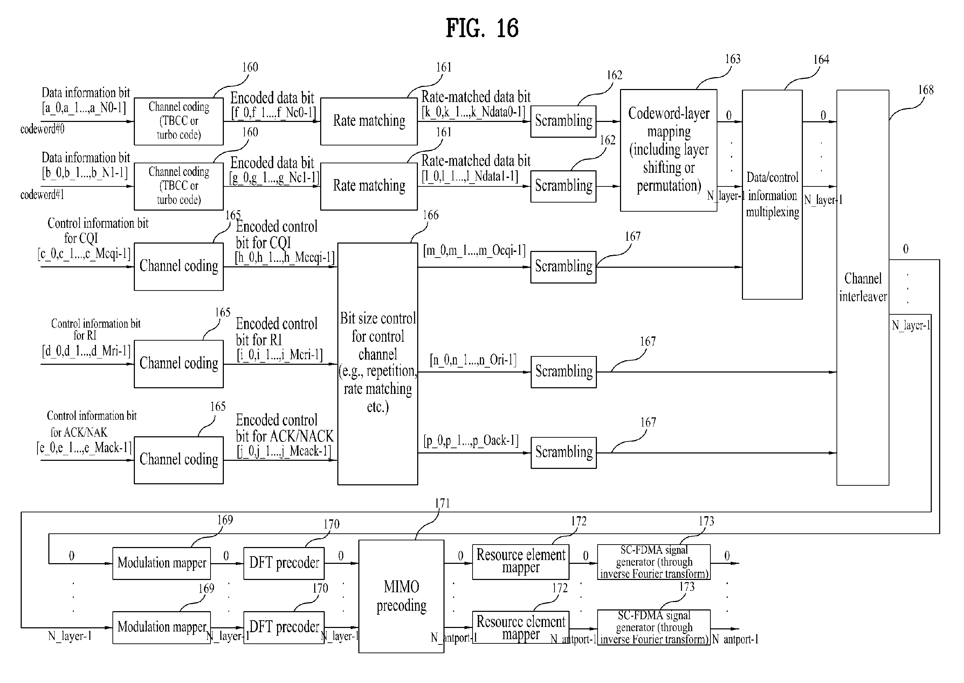

FIG. 16 is a block diagram illustrating a method for generating data and a transmission signal of a control channel. Positions of individual blocks can be changed to other positions according to various application schemes.

Referring to FIG. 16, assuming that two codewords are used, channel coding is performed for each codeword (See 160), and rate matching is performed according to a given MCS level and the size of a resource (See 161). In this case, encoded bits may be cell-specifically, UE-specifically, or codeword-specifically scrambled.

Thereafter, codeword-to-layer mapping is performed (See 163). The codeword-to-layer mapping may include a layer shift or permutation operation.

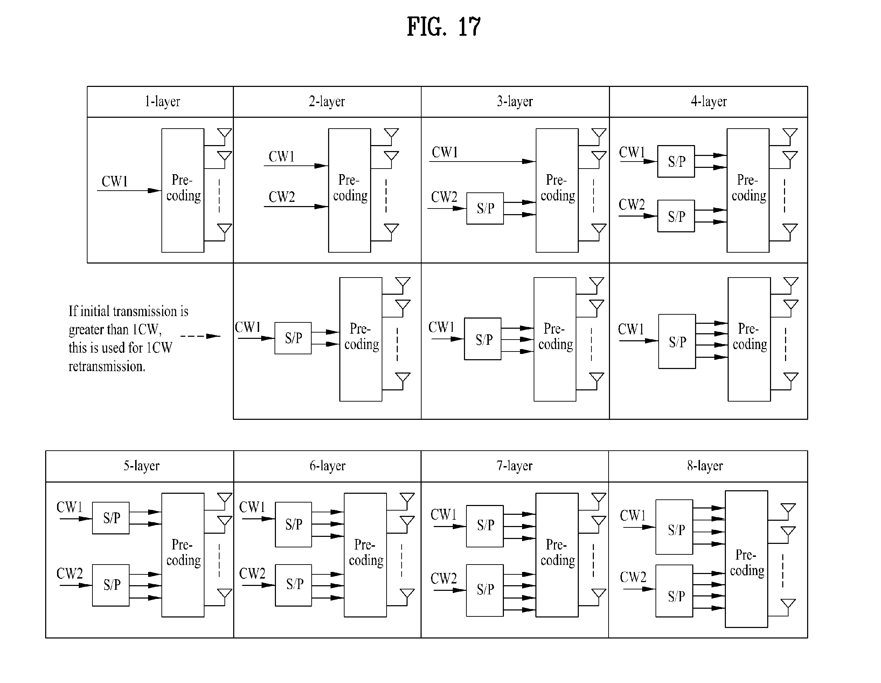

FIG. 17 is a conceptual diagram illustrating a codeword-to-layer mapping method. The codeword-to-layer mapping may be carried out using the rule shown in FIG. 17. The precoding position shown in FIG. 17 may be different from a precoding position shown in FIG. 13.

Control information (such as CQI, RI, and ACK/NACK) is channel-encoded according to a given specification (See 165). In this case, CQI, RI and ACK/NACK may be encoded by applying the same channel codes to all codewords, or may also be encoded by applying different channel codes to individual codewords.

Thereafter, the number of encoded bits may be changed by a bit-size controller (See 166). The bit-size controller may be integrated with the channel coding block 165. The output signals of the bit-size controller are scrambled (See 167). In this case, scrambling may be cell-specifically, layer-specifically, codeword-specifically, or UE-specifically performed.

The bit-size controller can be operated as follows.

(1) the controller recognizes a rank (n_rank_pusch) of PUSCH data.

(2) Rank (n_rank_control) of a control channel is identical to a rank of the data (i.e., n_rank_control = n_rank_pusch). The number (n_bit_ctrl) of bits for the control channel is multiplied by the rank of the control channel, such that the number of bits is extended.

One exemplary method for performing the above-mentioned operations is that the control channel is simply copied and repeated. In this case, the control channel may correspond to an information level acquired before channel coding, or may correspond to an encoded bit level acquired after channel coding. For example, when using not only control channels [a0, a1, a2, a3] corresponding to "n bit ctrl=4" but also "n rank pusch=2", the number (n_ext_ctrl) of extended bits may be 8 (i.e., [a0, a1, a2, a3, a0, a1, a2, a3]).

If the bit-size controller and the channel encoder are integrated into one module, the encoded bits can be generated using channel coding and rate matching defined in the legacy system (e.g., LTE Rel-8).

In addition to the bit-size controller, bit-level interleaving may be performed to expedite randomization for each layer. Equivalently to the bit-level interleaving, interleaving may be performed at a modulation symbol level.

CQI/PMI channel and data of two codewords can be multiplexed by a data/control multiplexer 164. Thereafter, ACK/NACK information is mapped to REs located in the vicinity of UL DM-RS at both slots of a subframe, and the channel interleaver 168 performs CQI/PMI mapping according to the time-first mapping scheme.

In addition, modulation of each layer is performed by a modulation mapper 169. DFT precoding 170, MIMO precoding 171, RE mapping 172, etc. are sequentially performed. Thereafter, an SC-FDMA signal is generated and transmitted through an antenna port (Step 173).

The above-mentioned functional blocks are not limited only to positions shown in FIG. 16, and positions of the functional blocks may be changed to other positions as necessary. For example, the scrambling blocks 162 and 167 may be located after the channel interleaving block. In addition, the codeword-to-layer mapping block 163 may be located either after the channel interleaving block 168 or after the modulation mapper block 169.

The present invention proposes not only a UCI channel coding method for the case in which UCI (such as CQI, ACK/NACK, RI) is transmitted over PUSCH, but also a resource allocation and transmission method related to the UCI channel coding method. Although the present invention assumes data transmission in the SU-MIMO environment for convenience of description and better understanding of the present invention, the scope or spirit of the present invention can also be applied to single-antenna transmission without change.

Presently, assuming that UCI and data are transmitted over a PUSCH according to the SU-MIMO scheme, the UCI and the data can be transmitted using the following scheme. The position of UCI on PUSCH will hereinafter be described in detail.

CQI is concatenated with data, and is then mapped to the remaining REs other than RI-mapped REs obtained by the time-first mapping scheme using the same modulation order and constellation as those of the data. In the case of SU-MIMO, CQI is spread and transmitted to one codeword. The codeword to which a CQI is transmitted is a codeword having a higher MCS level from among two codewords. If two codewords have the same MCS level, CQI is transmitted to Codeword 0. In addition, ACK/NACK is arranged simultaneously when concatenation of data and a CQI pre-mapped to symbols located at both sides of a reference signal (RS) is punctured. Since the RS is located at $3^{rd}$ and $10^{th}$ symbols, the mapping operation initially starts from the lowest subcarrier of each of the $2^{nd}$, $4^{th}$, $9^{th}$, and $11^{th}$ symbols, and sequentially proceeds to a higher subcarrier. In this case, mapping of ACK/NACK symbols is sequentially performed in the order of $2^{nd}$ symbol $\rightarrow$ $11^{th}$ symbol $\rightarrow$ $9^{th}$ symbol $\rightarrow$ $4^{th}$ symbol. RI is mapped to a symbol located next to ACK/NACK. From among all information (data, CQI, ACK/NACK, RI) transmitted to PUSCH, the RI has highest priority in the mapping order. In more detail, RI starts from the lowest subcarriers of $1^{st}$, $5^{th}$, $8^{th}$, and $12^{th}$ symbols and then proceeds to higher subcarriers in ascending numerical order. In this case, RI symbols are mapped in the order of first symbol $\rightarrow$ twelfth symbol $\rightarrow$ $8^{th}$ symbol $\rightarrow$ $5^{th}$ symbol. Specifically, ACK/NACK and RI are mapped using only four edges of the constellation under the condition that the size of information bit is denoted by 1 bit or 2 bits. Information bits of 3 bits or more can be mapped using all constellations having the same modulation order as that of data. In addition, ACK/NACK and RI can transmit the same information using the same resources located at the same positions within all layers.

A method for calculating the number of resource elements (REs) for UCI on PUSCH will hereinafter be described in detail. First of all, the number of resource elements (REs) for CQI and ACK/NACK (or RI) transmitted over PUSCH can be calculated according to Equation 1 and Equation 2.

[Equation 1]

$$Q' = \min\left(\left\lceil \frac{(O+L) \cdot M_{sc}^{PUSCH-initial} \cdot N_{symb}^{PUSCH-initial} \cdot \beta_{offset}^{PUSCH}}{\sum_{r=0}^{C^{(x)}-1} K_r^{(x)}} \right\rceil, M_{sc}^{PUSCH} \cdot N_{symb}^{PUSCH} - \frac{Q_{RI}}{Q_m}\right)$$

[Equation 2]

$$Q' = \min\left(\left\lceil \frac{O \cdot M_{sc}^{PUSCH-initial(1)} \cdot N_{symb}^{PUSCH-initial(1)} \cdot M_{sc}^{PUSCH-initial(2)} \cdot N_{symb}^{PUSCH-initial(2)} \cdot \beta_{offset}^{PUSCH}}{\sum_{r=0}^{C^{(1)}-1} K_r^{(1)} \cdot M_{sc}^{PUSCH-initial(2)} \cdot N_{symb}^{PUSCH-initial(2)} + \sum_{r=0}^{C^{(2)}-1} K_r^{(2)} \cdot M_{sc}^{PUSCH-initial(1)} \cdot N_{symb}^{PUSCH-initial(1)}} \right\rceil, 4 \cdot M_{sc}^{PUSCH}\right)$$

In Equations 1 and 2, the number of resource elements (REs) for CQI and ACK/NACK (or RI) can be denoted by the number of coded modulation symbols.

Hereinafter, a channel coding method for a UCI transmitted on PUSCH will be given below. First of all, assuming that CQI has a payload size of 11 bits or less, Reed-Muller (RM) coding is applied to input sequences (i.e., information data) $o_0, o_1, o_2, ..., o_{O-1}$ using the following table 1, output sequences of 32 bits are generated. In addition, assuming that CQI has a payload size of more than 11 bits, CRC of 8 bits is attached and TBCC (Tail Biting Convolutional Coding) is then applied to the CRC attachment result.

On the other hand, channel coding of ACK/NACK and RI transmitted over PUSCH will hereinafter be described.

If the size of ACK/NACK and RI information is denoted by 1 bit, i.e., if an input sequence is denoted by $[o_0^{UCI}]$, channel coding is performed according to the modulation order shown in Table 2. In addition, if the size of ACK/NACK and RI information is denoted by 2 bits, i.e., if an input sequence is denoted by $[o_0^{UCI} \; o_1^{UCI}]$, channel coding is performed according to the modulation order shown in Table 3. Specifically, as shown in Table 3, $o_0^{UCI}$ corresponds to ACK/NACK or RI data for Codeword 0, $o_1^{UCI}$ corresponds to ACK/NACK or RI data for Codeword 1, and $o_2^{UCI}$ corresponds to $(o_0^{UCI} + o_1^{UCI}) \bmod 2$. Specifically, as shown in Tables 2 and 3, x denotes the value of 1, and y denotes iteration of a former or previous value.

However, assuming that the size of ACK/NACK and RI information is denoted by any one of 3 ~ 11 bits, RM coding based on Table 2 is applied such that output sequences of 32 bits are generated.

[Table 1]

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ |
|---|---|---|---|---|---|---|---|---|---|---|---|
| 0 | 1 | 1 | 0 | 0 | 0 | 0 | 0 | 0 | 0 | 0 | 1 |
| 1 | 1 | 1 | 1 | 0 | 0 | 0 | 0 | 0 | 0 | 1 | 1 |
| 2 | 1 | 0 | 0 | 1 | 0 | 0 | 1 | 0 | 1 | 1 | 1 |
| 3 | 1 | 0 | 1 | 1 | 0 | 0 | 0 | 0 | 1 | 0 | 1 |
| 4 | 1 | 1 | 1 | 1 | 0 | 0 | 0 | 1 | 0 | 0 | 1 |
| 5 | 1 | 1 | 0 | 0 | 1 | 0 | 1 | 1 | 1 | 0 | 1 |
| 6 | 1 | 0 | 1 | 0 | 1 | 0 | 1 | 0 | 1 | 1 | 1 |
| 7 | 1 | 0 | 0 | 1 | 1 | 0 | 0 | 1 | 1 | 0 | 1 |
| 8 | 1 | 1 | 0 | 1 | 1 | 0 | 0 | 1 | 0 | 1 | 1 |
| 9 | 1 | 0 | 1 | 1 | 1 | 0 | 1 | 0 | 0 | 1 | 1 |
| 10 | 1 | 0 | 1 | 0 | 0 | 1 | 1 | 1 | 0 | 1 | 1 |
| 11 | 1 | 1 | 1 | 0 | 0 | 1 | 1 | 0 | 1 | 0 | 1 |
| 12 | 1 | 0 | 0 | 1 | 0 | 1 | 0 | 1 | 1 | 1 | 1 |
| 13 | 1 | 1 | 1 | 1 | 0 | 1 | 0 | 1 | 0 | 1 | 1 |
| 14 | 1 | 0 | 0 | 0 | 1 | 1 | 0 | 1 | 0 | 0 | 1 |
| 15 | 1 | 1 | 0 | 0 | 1 | 1 | 1 | 1 | 0 | 1 | 1 |
| 16 | 1 | 1 | 1 | 0 | 1 | 1 | 1 | 0 | 0 | 1 | 0 |
| 17 | 1 | 0 | 0 | 1 | 1 | 1 | 0 | 0 | 1 | 0 | 0 |

(continued)

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ |
|---|---|---|---|---|---|---|---|---|---|---|---|
| 18 | 1 | 1 | 0 | 1 | 1 | 1 | 1 | 1 | 0 | 0 | 0 |
| 19 | 1 | 0 | 0 | 0 | 0 | 1 | 1 | 0 | 0 | 0 | 0 |
| 20 | 1 | 0 | 1 | 0 | 0 | 0 | 1 | 0 | 0 | 0 | 1 |
| 21 | 1 | 1 | 0 | 1 | 0 | 0 | 0 | 0 | 0 | 1 | 1 |
| 22 | 1 | u | 0 | 0 | 1 | 0 | 0 | 1 | 1 | 0 | 1 |
| 23 | 1 | 1 | 1 | 0 | 1 | 0 | 0 | 0 | 1 | 1 | 1 |
| 24 | 1 | 1 | 1 | 1 | 1 | 0 | 1 | 1 | 1 | 1 | 0 |
| 25 | 1 | 1 | 0 | 0 | 0 | 1 | 1 | 1 | 0 | 0 | 1 |
| 26 | 1 | 0 | 1 | 1 | 0 | 1 | 0 | 0 | 1 | 1 | 0 |
| 27 | 1 | 1 | 1 | 1 | 0 | 1 | 0 | 1 | 1 | 1 | 0 |
| 28 | 1 | 0 | 1 | 0 | 1 | 1 | 1 | 0 | 1 | 0 | 0 |
| 29 | 1 | 0 | 1 | 1 | 1 | 1 | 1 | 1 | 1 | 0 | 0 |
| 30 | 1 | 1 | 1 | 1 | 1 | 1 | 1 | 1 | 1 | 1 | 1 |
| 31 | 1 | 0 | 0 | 0 | 0 | 0 | 0 | 0 | 0 | 0 | 0 |

[Table 2]

| $4.1.x.13.Q_m$ | $4.1.x.14.$Encoded HARQ-ACK/RI |
|---|---|
| 2 | $\begin{bmatrix} o_0^{UCI} & y \end{bmatrix}$ |
| 4 | $\begin{bmatrix} o_0^{UCI} & y & x & x \end{bmatrix}$ |
| 6 | $\begin{bmatrix} o_0^{UCI} & y & x & x & x & x \end{bmatrix}$ |

[Table 3]

| $4.1.x.15.Q_m$ | $4.1.x.16$ Encoded HARQ-ACK/RI |
|---|---|
| 2 | $\begin{bmatrix} o_0^{UCI} & o_1^{UCI} & o_2^{UCI} & o_0^{UCI} & o_1^{UCI} & o_2^{UCI} \end{bmatrix}$ |
| 4 | $\begin{bmatrix} o_0^{UCI} & o_1^{UCI} & x & x & o_2^{UCI} & o_0^{UCI} & x & x & o_1^{UCI} & o_2^{UCI} & x & x \end{bmatrix}$ |
| 6 | $\begin{bmatrix} o_0^{UCI} & o_1^{UCI} & x & x & x & x & o_2^{UCI} & o_0^{UCI} & x & x & x & x & o_1^{UCI} & o_2^{UCI} & x & x & x & x \end{bmatrix}$ |

Specifically, in the case of RM coding based on Table 1, output data $b_0, b_1, b_2, b_2, ... b_{B-1}$ is represented by the following equation 3, and B is denoted by 3 (B=32).

[Equation 3]

$$b_i = \sum_{n=0}^{O-1} \left( o_n \cdot M_{i,n} \right) \bmod 2$$

Finally, UCI (i.e., ACK/NACK or RI) encoded with B bits can be rate-matched according to the following equation 4, such that it can be mapped to Q' resource elements (REs) calculated by Equations 1 and 2.

[Equation 4]

$$q_i = b_{i \bmod B}, \quad i = 0,1,\cdots, Q_m \times Q'-1$$

As a channel code that has been applied to a PUCCH CQI of the legacy LTE-A, a (20,A) code generated through the RM-code puncturing process has been used. The reason why the (20,A) code is reused is as follows. First, since the (20,A) code matrix can be considered to be a puncturing code modified by puncturing the RM code, decoding can be simplified through Fast Hadamard Transform and the simplified result can be obtained at a high speed. A (20,A) code matrix can be supported by the size of information bit and the size of codeword bits in various ways, such that the (20,A) code matrix is suitable for requirements of the CQI code. In association with the decoder, the (20,A) code matrix is also suitable for hardware of a WCDMA and LTE dual-mode system.

Puncturing applicable to the RM code so as to construct the (20,A) code matrix will hereinafter be described with reference to Tables 4 and 5.

The puncturing scheme can be implemented by the entire-quantity searching through computer simulation. In this case, a (18,A) code matrix can be calculated using the (20,A) code matrix. The (18,A) puncturing scheme does not have a different structure, and includes a hierarchical structure constructed by applying two additional puncturing processes to the (20,A) puncturing format. The (18,A) code can be generated from both the (32, A) code and the (20, A) code. The following Table 4 shows a method for puncturing the (32,A) code to generate the (20,A) code and the (18,A) code.

[Table 4]

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | Puncturing pattern | |
|---|---|---|---|---|---|---|---|---|---|---|---|---|
| | | | | | | | | | | | (10, 20) | (18,10) |
| 0 | 1 | 0 | 0 | 0 | 0 | 1 | 0 | 0 | 0 | 0 | | |
| 1 | | | | | | | | | | | Punctured | Punctured |
| 2 | 1 | 1 | 0 | 0 | 0 | 1 | 0 | 0 | 0 | 1 | | |
| 3 | 0 | 0 | 1 | 0 | 0 | 1 | 1 | 0 | 1 | 1 | | |
| 4 | | | | | | | | | | | Punctured | Punctured |
| 5 | 0 | 1 | 1 | 0 | 0 | 1 | 0 | 0 | 1 | 0 | | |
| 6 | 1 | 1 | 1 | 0 | 0 | 1 | 0 | 1 | 0 | 0 | | |
| 7 | | | | | | | | | | | Punctured | Punctured |
| 8 | 1 | 0 | 0 | 1 | 0 | 1 | 1 | 1 | 1 | 0 | | |
| 9 | 0 | 1 | 0 | 1 | 0 | 1 | 1 | 0 | 1 | 1 | | |
| 10 | | | | | | | | | | | Punctured | Punctured |
| 11 | 0 | 0 | 1 | 1 | 0 | 1 | 0 | 1 | 1 | 0 | | |
| 12 | 1 | 0 | 1 | 1 | 0 | 1 | 0 | 1 | 0 | 1 | | |
| 13 | 0 | 1 | 1 | 1 | 0 | 1 | 1 | 0 | 0 | 1 | | |
| 14 | | | | | | | | | | | Punctured | Punctured |
| 15 | | | | | | | | | | | Punctured | Punctured |
| 16 | 0 | 1 | 0 | 0 | 1 | 1 | 1 | 1 | 0 | 1 | | |
| 17 | 1 | 1 | 0 | 0 | 1 | 1 | 1 | 0 | 1 | 0 | | |
| 18 | 0 | 0 | 1 | 0 | 1 | 1 | 0 | 1 | 1 | 1 | | |
| 19 | 1 | 0 | 1 | 0 | 1 | 1 | 0 | 1 | 0 | 1 | | |
| 20 | | | | | | | | | | | Punctured | Punctured |
| 21 | | | | | | | | | | | Punctured | Punctured |
| 22 | 0 | 0 | 0 | 1 | 1 | 1 | 0 | 1 | 0 | 0 | | |
| 23 | 1 | 0 | 0 | 1 | 1 | 1 | 1 | 1 | 0 | 1 | | |
| 24 | | | | | | | | | | | Punctured | Punctured |
| 25 | 1 | 1 | 0 | 1 | 1 | 1 | 1 | 0 | 0 | 1 | | |
| 26 | 0 | 0 | 1 | 1 | 1 | 1 | 0 | 0 | 1 | 0 | | |
| 27 | | | | | | | | | | | | - |
| 28 | | | | | | | | | | | Punctured | Punctured |
| 29 | | | | | | | | | | | Punctured | Punctured |
| 30 | | | | | | | | | | | Punctured | Punctured |
| 31 | | | | | | | | | | | | |

The result of minimum-distance performance of the above-mentioned codes is shown in Table 5.

[Table 5]

| n \ k | 4 | 5 | 6 | 7 | 8 | 9 | 10 |
|---|---|---|---|---|---|---|---|
| 20 | 8 | 8 | 8 | 6 | 6 | 6 | |
| 18 | 8 | 6 | 6 | 5 | 5 | 4 | 4 |

(20,A) code matrix generated by the above-mentioned (32,A)-code puncturing is shown in the following table 6.

[Table 6]

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ | $M_{i,11}$ | $M_{i,12}$ |
|---|---|---|---|---|---|---|---|---|---|---|---|---|---|
| 0 | 1 | 1 | 0 | 0 | 0 | 0 | 0 | 0 | 0 | 0 | 1 | 1 | 0 |
| 1 | 1 | 1 | 1 | 0 | 0 | 0 | 0 | 0 | 0 | 1 | 1 | 1 | 0 |
| 2 | 1 | 0 | 0 | 1 | 0 | 0 | 1 | 0 | 1 | 1 | 1 | 1 | 1 |
| 3 | 1 | 0 | 1 | 1 | 0 | 0 | 0 | 0 | 1 | 0 | 1 | 1 | 1 |
| 4 | 1 | 1 | 1 | 1 | 0 | 0 | 0 | 1 | 0 | 0 | 1 | 1 | 1 |
| 5 | 1 | 1 | 0 | 0 | 1 | 0 | 1 | 1 | 1 | 0 | 1 | 1 | 1 |
| 6 | 1 | 0 | 1 | 0 | 1 | 0 | 1 | 0 | 1 | 1 | 1 | 1 | 1 |
| 7 | 1 | 0 | 0 | 1 | 1 | 0 | 0 | 1 | 1 | 0 | 1 | 1 | 1 |
| 8 | 1 | 1 | 0 | 1 | 1 | 0 | 0 | 1 | 0 | 1 | 1 | 1 | 1 |
| 9 | 1 | 0 | 1 | 1 | 1 | 0 | 1 | 0 | 0 | 1 | 1 | 1 | 1 |
| 10 | 1 | 0 | 1 | 0 | 0 | 1 | 1 | 1 | 0 | 1 | 1 | 1 | 1 |
| 11 | 1 | 1 | 1 | 0 | 0 | 1 | 1 | 0 | 1 | 0 | 1 | 1 | 1 |
| 12 | 1 | 0 | 0 | 1 | 0 | 1 | 0 | 1 | 1 | 1 | 1 | 1 | 1 |
| 13 | 1 | 1 | 0 | 1 | 0 | 1 | 0 | 1 | 0 | 1 | 1 | 1 | 1 |
| 14 | 1 | 0 | 0 | 0 | 1 | 1 | 0 | 1 | 0 | 0 | 1 | 0 | 1 |
| 15 | 1 | 1 | 0 | 0 | 1 | 1 | 1 | 1 | 0 | 1 | 1 | 0 | 1 |
| 16 | 1 | 1 | 1 | 0 | 1 | 1 | 1 | 0 | 0 | 1 | 0 | 1 | 1 |
| 17 | 1 | 0 | 0 | 1 | 1 | 1 | 0 | 0 | 1 | 0 | 0 | 1 | 1 |
| 18 | 1 | 1 | 0 | 1 | 1 | 1 | 1 | 1 | 0 | 0 | 0 | 0 | 0 |
| 19 | 1 | 0 | 0 | 0 | 0 | 1 | 1 | 0 | 0 | 0 | 0 | 0 | 0 |

Channel coding is applied to PUCCH CQI using the above-mentioned concept shown in Table 6. That is, (20,A) channel coding shown in Table 6 is applied to CQI input data $\alpha_n$, such that output data $b_i$ of 20 bits is generated. The output sequence (data) $b_i$ can be represented by the following equation 5.

[Equation 5]

$$b_i = \sum_{n=0}^{A-1} \left( a_n \cdot M_{i,n} \right) \mod 2$$

In Equation 5, $M_{i,n}$ is the (20,A) code matrix, $i$ is a row index, and $n$ is a column index.

Referring to the generated (20,A) code matrix, it can be recognized that an interval in which contiguous '0' values are generated frequently appears. If the contiguous '0' values are present, no channel information is contained in symbols to be transmitted in the QPSK mode, such that it can deteriorate efficient communication.

In case of $M_{i,5}$ indicating the 6th column of the (20,A) code matrix, only '0' is present in ten upper columns and '1' is present in ten lower rows, so that information can be transmitted only to the ten lower rows. As a result, although two slots are actually used to transmit information, the actual effect is as if the information were transmitted only to one slot according to channel condition. If discrimination per bit is not achieved in the corresponding slot, it is impossible to guarantee desired performance.

Therefore, if input data has the size of 6 bits or more, information of the 6th bit is not reflected in the input data, such that it is difficult to normally obtain a diversity indicating LTE-A PUCCH transmission characteristics transmitted when two slots are allowed, resulting in deterioration of system performance.

The present invention proposes a new structure of the (20,A) code applied to PUCCH. The newly proposed structure rearranges a specific part causing performance deterioration in a legacy channel code, such that it can solve legacy problems.

A detailed description will be given of a method for rearranging the specific part causing performance deterioration so as to generate a new code matrix.

**<First Embodiment - Method for generating new code matrix by cyclically shifting a row by a predetermined column-directional size>**

In accordance with one embodiment of the present invention, a row of the (20,A) code matrix is cyclically shifted by a predetermined column-directional size such that a new code matrix can be generated.

The cyclic-shift direction can be applied to up and down directions. A cyclic-shift size can be changed to an arbitrary size.

In this case, the result obtained when a row of the (20,A) code matrix is cyclically shifted upward by 'A' is identical to the result obtained when the row of the (20,A) code matrix is cyclically shifted downward by '20-A'. When using frequency hopping on PUCCH, encoded data is transmitted to two different slots, such that the effect obtained when an upper half of generated codes was changed is identical to the effect obtained when a lower half of the generated codes was changed. Therefore, the resultant matrix obtained when a row is cyclically shifted upward by 'A' in the (20,A) code matrix is identical to either a matrix obtained when a row is cyclically shifted upward by '10+A' or a matrix obtained when a row is cyclically shifted downward by '10-A'.

On the other hand, the cyclic shift may be achieved only when the bit size of CQI data is denoted by at least a predetermined number of bits.

Particularly, assuming that the size of input data for use in the (20,A) code matrix is less than 6 bits, performance is not deteriorated. In contrast, assuming that the size of input data for use in the (20,A) code matrix is denoted by 6 bits or more, it is impossible to reflect the input data to the 6th bit information, such that a predetermined number of the bit size of the CQI data may be set to 6.

However, generating the cyclically shifted code matrix only when the above bit size is denoted by a predetermined number or higher is disclosed only for illustrative purpose, and the scope or spirit of the present invention is not limited thereto.

A row of the (20,A) code matrix can be cyclically shifted in a row direction by any one of 1 to 9 values. Newly changed channel coding is applied to CQI input data $\alpha_n$, such that output data $b_i$ of 20 bits can be generated. The output sequence (data) $b_i$ applied to the changed channel coding can be denoted by the following equation 6.

[Equation 6]

$$b_i = \sum_{n=0}^{A-1} \left( a_n \cdot M_{i,n}' \right) \bmod 2$$

In Equation 6, $M_{i,n}$ is a newly generated code matrix, and $i'$ is denoted by $(i+k)\bmod 20$ and k is an integer. That is, a code matrix being cyclically shifted by 'k' is applied. If the value of $i+k$ is higher than 20, a specific value to which the 'mod 20' function is applied can be used.

When generating a new code matrix by cyclically shifting a row by a predetermined size, the enhanced performance results will hereinafter be described with reference to Tables 7, 15 and 18.

Table 7 shows the resultant code matrix obtained when a row of the (20,A) code matrix is cyclically shifted upward by a value of 1. The above code matrix is identical to a code matrix obtained when a row of the (20,A) code matrix is cyclically shifted downward by a value of 19. In addition, the above code matrix is identical to the resultant code matrix obtained when a row of the (20,A) code matrix is cyclically shifted upward by a value of 11, and is also identical to the other code matrix obtained when a row of the (20,A) code matrix is cyclically shifted downward by a value of 9.

[Table 7]

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ | $M_{i,11}$ | $M_{i,12}$ |
|---|---|---|---|---|---|---|---|---|---|---|---|---|---|
| 0 | 1 | 1 | 1 | 0 | 0 | 0 | 0 | 0 | 0 | 1 | 1 | 1 | 0 |
| 1 | 1 | 0 | 0 | 1 | 0 | 0 | 1 | 0 | 1 | 1 | 1 | 1 | 1 |
| 2 | 1 | 0 | 1 | 1 | 0 | 0 | 0 | 0 | 1 | 0 | 1 | 1 | 1 |

(continued)

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ | $M_{i,11}$ | $M_{i,12}$ |
|---|---|---|---|---|---|---|---|---|---|---|---|---|---|
| 3 | 1 | 1 | 1 | 1 | 0 | 0 | 0 | 1 | 0 | 0 | 1 | 1 | 1 |
| 4 | 1 | 1 | 0 | 0 | 1 | 0 | 1 | 1 | 1 | 0 | 1 | 1 | 1 |
| 5 | 1 | 0 | 1 | 0 | 1 | 0 | 1 | 0 | 1 | 1 | 1 | 1 | 1 |
| 6 | 1 | 0 | 0 | 1 | 1 | 0 | 0 | 1 | 1 | 0 | 1 | 1 | 1 |
| 7 | 1 | 1 | 0 | 1 | 1 | 0 | 0 | 1 | 0 | 1 | 1 | 1 | 1 |
| 8 | 1 | 0 | 1 | 1 | 1 | 0 | 1 | 0 | 0 | 1 | 1 | 1 | 1 |
| 9 | 1 | 0 | 1 | 0 | 0 | 1 | 1 | 1 | 0 | 1 | 1 | 1 | 1 |
| 10 | 1 | 1 | 1 | 0 | 0 | 1 | 1 | 0 | 1 | 0 | 1 | 1 | 1 |
| 11 | 1 | 0 | 0 | 1 | 0 | 1 | 0 | 1 | 1 | 1 | 1 | 1 | 1 |
| 12 | 1 | 1 | 0 | 1 | 0 | 1 | 0 | 1 | 0 | 1 | 1 | 1 | 1 |
| 13 | 1 | 0 | 0 | 0 | 1 | 1 | 0 | 1 | 0 | 0 | 1 | 0 | 1 |
| 14 | 1 | 1 | 0 | 0 | 1 | 1 | 1 | 1 | 0 | 1 | 1 | 0 | 1 |
| 15 | 1 | 1 | 1 | 0 | 1 | 1 | 1 | 0 | 0 | 1 | 0 | 1 | 1 |
| 16 | 1 | 0 | 0 | 1 | 1 | 1 | 0 | 0 | 1 | 0 | 0 | 1 | 1 |
| 17 | 1 | 1 | 0 | 1 | 1 | 1 | 1 | 1 | 0 | 0 | 0 | 0 | 0 |
| 18 | 1 | 0 | 0 | 0 | 0 | 1 | 1 | 0 | 0 | 0 | 0 | 0 | 0 |
| 19 | 1 | 1 | 0 | 0 | 0 | 0 | 0 | 0 | 0 | 0 | 1 | 1 | 0 |

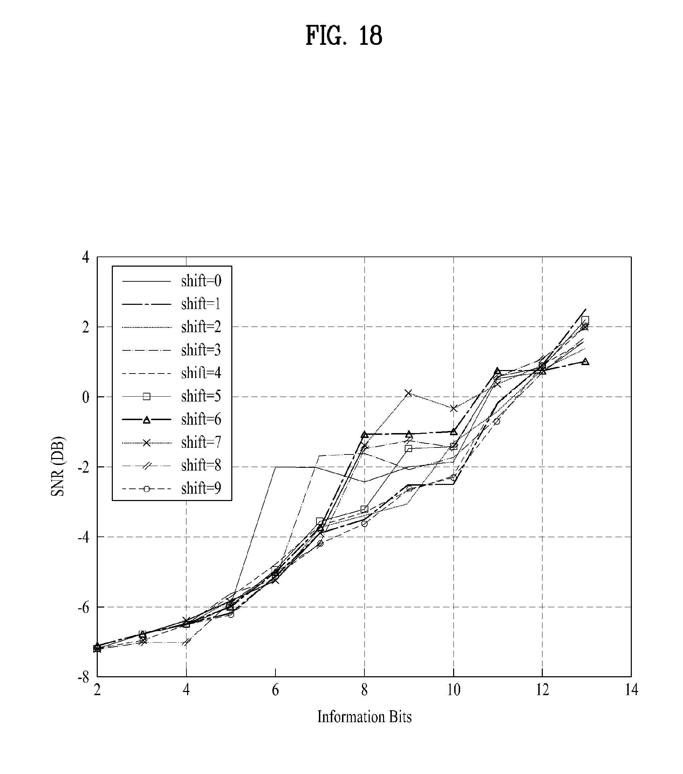

Performance variation of the resultant code matrix obtained when a row of the (20,A) code matrix is cyclically shifted upward by a value of 1 will hereinafter be described with reference to FIG. 18.

FIG. 18 shows exemplary performance resultant values using a code matrix generated by cyclically shifting a row by a predetermined column-directional size. Referring to FIG. 18, when a column is cyclically shifted upward by a value of 1, it can be easily recognized that superior performance is achieved when input information is 10 bits long. Therefore, when considering the information size of 10 bits in association with the bit size of CQI data, performance improvement can be achieved using the resultant code matrix obtained when a row is cyclically shifted upward by a value of 1.

In this case, the 10 upper rows of the resultant code matrix can be replaced with the 10 lower rows thereof. The same-value cyclic shift or a different-value cyclic shift can be applied to the ten upper rows and the ten lower rows.

Alternatively, the positions of columns of the (20,A) code matrix can be exchanged with each other. A method for cyclically shifting the generated resultant code within a group of the same-order columns, or a method for exchanging each column with another column within a group of the same-order columns can be applied.

The resultant code matrix obtained when a row of the (20,A) code matrix is cyclically shifted upward by a value of 2 is shown in Table 8. In this case, the resultant code matrix is equal to a code matrix obtained when a row of the (20,A) code matrix is cyclically shifted downward by a value of 18. In addition, the resultant code matrix is identical to a code matrix obtained when a row of the (20,A) code matrix is cyclically shifted upward by a value of 12, or is also identical to a code matrix obtained when a row of the (20,A) code matrix is cyclically shifted downward by a value of 8.

[Table 8]

| i | Mi,0 | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ | $M_{i,11}$ | $M_{i,12}$ |
|---|---|---|---|---|---|---|---|---|---|---|---|---|---|
| 0 | 1 | 0 | 0 | 1 | 0 | 0 | 1 | 0 | 1 | 1 | 1 | 1 | 1 |
| 1 | 1 | 0 | 0 | 1 | 0 | 0 | 0 | 0 | 1 | 0 | 1 | 1 | 1 |
| 2 | 1 | 1 | 1 | 1 | 0 | 0 | 0 | 1 | 0 | 0 | 1 | 1 | 1 |
| 3 | 1 | 1 | 0 | 0 | 1 | 0 | 1 | 1 | 0 | 0 | 1 | 1 | 1 |
| 4 | 1 | 0 | 1 | 0 | 1 | 0 | 1 | 0 | 1 | 1 | 1 | 1 | 1 |

(continued)

| i | Mi,0 | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ | $M_{i,11}$ | $M_{i,12}$ |
|---|---|---|---|---|---|---|---|---|---|---|---|---|---|
| 5 | 1 | 0 | 0 | 1 | 1 | 0 | 0 | 1 | 1 | 0 | 1 | 1 | 1 |
| 6 | 1 | 1 | 0 | 1 | 1 | 0 | 0 | 1 | 0 | 1 | 1 | 1 | 1 |
| 7 | 1 | 0 | 1 | 1 | 1 | 0 | 1 | 0 | 0 | 1 | 1 | 1 | 1 |
| 8 | 1 | 0 | 1 | 0 | 0 | 1 | 1 | 1 | 0 | 1 | 1 | 1 | 1 |
| 9 | 1 | 1 | 1 | 0 | 0 | 1 | 1 | 0 | 1 | 0 | 1 | 1 | 1 |
| 10 | 1 | 0 | 0 | 1 | 0 | 1 | 0 | 1 | 1 | 1 | 1 | 1 | 1 |
| 11 | 1 | 1 | 0 | 1 | 0 | 1 | 0 | 1 | 0 | 1 | 1 | 1 | 1 |
| 12 | 1 | 0 | 0 | 0 | 1 | 1 | 0 | 1 | 0 | 0 | 1 | 0 | 1 |
| 13 | 1 | 1 | 0 | 0 | 1 | 1 | 1 | 1 | 0 | 1 | 1 | 0 | 1 |
| 14 | 1 | 1 | 1 | 0 | 1 | 1 | 1 | 0 | 0 | 1 | 0 | 1 | 1 |
| 15 | 1 | 0 | 0 | 1 | 1 | 1 | 0 | 0 | 1 | 0 | 0 | 1 | 1 |
| 16 | 1 | 1 | 0 | 1 | 1 | 1 | 1 | 1 | 0 | 0 | 0 | 0 | 0 |
| 17 | 1 | 0 | 0 | 0 | 0 | 1 | 1 | 0 | 0 | 0 | 0 | 0 | 0 |
| 18 | 1 | 1 | 0 | 0 | 0 | 0 | 0 | 0 | 0 | 0 | 1 | 1 | 0 |
| 19 | 1 | 1 | 1 | 0 | 0 | 0 | 0 | 0 | 0 | 1 | 1 | 1 | 0 |

Performance variation of the resultant code matrix shown in Table 8 will hereinafter be described with reference to FIG. 18.

Referring to FIG. 18, when a row is cyclically shifted upward by a value of 2, it can be easily recognized that superior performance is achieved when input information is 9 bits long. Therefore, when considering the information size of 9 bits in association with the bit size of CQI data, performance improvement can be achieved using the resultant code matrix obtained when a row is cyclically shifted upward by a value of 2.

In this case, the 10 upper rows of the resultant code matrix can be replaced with the 10 lower rows thereof. The same-value cyclic shift or a different-value cyclic shift can be applied to the ten upper rows and the ten lower rows.

Alternatively, the positions of columns of the (20,A) code matrix can be exchanged with each other. A method for cyclically shifting the generated resultant code within a group of the same-order columns, or a method for exchanging each column with another column within a group of the same-order columns can be applied.

Meanwhile, the resultant code matrix obtained when a row of the (20,A) code matrix is cyclically shifted upward by a value of 3 is shown in Table 9. In this case, the resultant code matrix is equal to a code matrix obtained when a row of the (20,A) code matrix is cyclically shifted downward by a value of 17. In addition, the resultant code matrix is identical to a code matrix obtained when a row of the (20,A) code matrix is cyclically shifted upward by a value of 13, or is also identical to a code matrix obtained when a row of the (20,A) code matrix is cyclically shifted downward by a value of 7.

[Table 9]

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ | $M_{i,11}$ | $M_{i,12}$ |
|---|---|---|---|---|---|---|---|---|---|---|---|---|---|
| 0 | 1 | 0 | 1 | 1 | 0 | 0 | 0 | 0 | 1 | 0 | 1 | 1 | 1 |
| 1 | 1 | 1 | 1 | 1 | 0 | 0 | 0 | 1 | 0 | 0 | 1 | 1 | 1 |
| 2 | 1 | 1 | 0 | 0 | 1 | 0 | 1 | 1 | 1 | 0 | 1 | 1 | 1 |
| 3 | 1 | 0 | 1 | 0 | 1 | 0 | 1 | 0 | 1 | 1 | 1 | 1 | 1 |
| 4 | 1 | 0 | 0 | 1 | 1 | 0 | 0 | 1 | 1 | 0 | 1 | 1 | 1 |
| 5 | 1 | 1 | 0 | 1 | 1 | 0 | 0 | 1 | 0 | 1 | 1 | 1 | 1 |
| 6 | 1 | 0 | 1 | 1 | 1 | 0 | 1 | 0 | 0 | 1 | 1 | 1 | 1 |
| 7 | 1 | 0 | 1 | 0 | 0 | 1 | 1 | 1 | 0 | 1 | 1 | 1 | 1 |

(continued)

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ | $M_{i,11}$ | $M_{i,12}$ |
|---|---|---|---|---|---|---|---|---|---|---|---|---|---|
| 9 | 1 | 1 | 1 | 0 | 0 | 1 | 1 | 0 | 1 | 0 | 1 | 1 | 1 |
| 9 | 1 | 0 | 0 | 1 | 0 | 1 | 0 | 1 | 1 | 1 | 1 | 1 | 1 |
| 10 | 1 | 1 | 0 | 1 | 0 | 1 | 0 | 1 | 0 | 1 | 1 | 1 | 1 |
| 11 | 1 | 0 | 0 | 0 | 1 | 1 | 0 | 1 | 0 | 0 | 1 | 0 | 1 |
| 12 | 1 | 1 | 0 | 0 | 1 | 1 | 1 | 1 | 0 | 1 | 1 | 0 | 1 |
| 13 | 1 | 1 | 1 | 0 | 1 | 1 | 1 | 0 | 0 | 1 | 0 | 1 | 1 |
| 14 | 1 | 0 | 0 | 1 | 1 | 1 | 0 | 0 | 1 | 0 | 0 | 1 | 1 |
| 15 | 1 | 1 | 0 | 1 | 1 | 1 | 1 | 1 | 0 | 0 | 0 | 0 | 0 |
| 16 | 1 | 0 | 0 | 0 | 0 | 1 | 1 | 0 | 0 | 0 | 0 | 0 | 0 |
| 17 | 1 | 1 | 0 | 0 | 0 | 0 | 0 | 0 | 0 | 0 | 1 | 1 | 0 |
| 18 | 1 | 1 | 1 | 0 | 0 | 0 | 0 | 0 | 0 | 1 | 1 | 1 | 0 |
| 19 | 1 | 0 | 0 | 1 | 0 | 0 | 1 | 0 | 1 | 1 | 1 | 1 | 1 |

Performance variation of the resultant code matrix shown in Table 9 will hereinafter be described with reference to FIG. 18.

Referring to FIG. 18, when a row is cyclically shifted upward by a value of 3, it can be easily recognized that superior performance is achieved when input information is 12 bits long. Therefore, when considering the information size of 12 bits in association with the bit size of CQI data, performance improvement can be achieved using the resultant code matrix obtained when a row is cyclically shifted upward by a value of 3.

In this case, the 10 upper rows of the resultant code matrix can be replaced with the 10 lower rows thereof. The same-value cyclic shift or a different-value cyclic shift can be applied to the ten upper rows and the ten lower rows.

Alternatively, the positions of columns of the (20,A) code matrix can be exchanged with each other. A method for cyclically shifting the generated resultant code within a group of the same-order columns, or a method for exchanging each column with another column within a group of the same-order columns can be applied.

Meanwhile, the resultant code matrix obtained when a row of the (20,A) code matrix is cyclically shifted upward by a value of 4 is shown in Table 10. In this case, the resultant code matrix is equal to a code matrix obtained when a row of the (20,A) code matrix is cyclically shifted downward by a value of 16. In addition, the resultant code matrix is identical to a code matrix obtained when a row of the (20,A) code matrix is cyclically shifted upward by a value of 14, or is also identical to a code matrix obtained when a row of the (20,A) code matrix is cyclically shifted downward by a value of 6.

[Table 10]

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ | $M_{i,11}$ | $M_{i,12}$ |
|---|---|---|---|---|---|---|---|---|---|---|---|---|---|
| 0 | 1 | 1 | 1 | 1 | 0 | 0 | 0 | 1 | 0 | 0 | 1 | 1 | 1 |
| 1 | 1 | 1 | 0 | 0 | 1 | 0 | 1 | 1 | 1 | 0 | 1 | 1 | 1 |
| 2 | 1 | 0 | 1 | 0 | 1 | 0 | 1 | 0 | 1 | 1 | 1 | 1 | 1 |
| 3 | 1 | 0 | 0 | 1 | 1 | 0 | 0 | 1 | 1 | 0 | 1 | 1 | 1 |
| 4 | 1 | 1 | 0 | 1 | 1 | 0 | 0 | 1 | 0 | 1 | 1 | 1 | 1 |
| 5 | 1 | 0 | 1 | 1 | 1 | 0 | 1 | 0 | 0 | 1 | 1 | 1 | 1 |
| 6 | 1 | 0 | 1 | 0 | 0 | 1 | 1 | 1 | 0 | 1 | 1 | 1 | 1 |
| 7 | 1 | 1 | 1 | 0 | 0 | 1 | 1 | 0 | 1 | 0 | 1 | 1 | 1 |
| 9 | 1 | 0 | 0 | 1 | 0 | 1 | 0 | 1 | 1 | 1 | 1 | 1 | 1 |
| 10 | 1 | 1 | 0 | 1 | 0 | 1 | 0 | 1 | 0 | 1 | 1 | 1 | 1 |
| 10 | 1 | 0 | 0 | 0 | 1 | 1 | 0 | 1 | 0 | 1 | 1 | 0 | 1 |

(continued)

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ | $M_{i,11}$ | $M_{i,12}$ |
|---|---|---|---|---|---|---|---|---|---|---|---|---|---|
| 11 | 1 | 1 | 0 | 0 | 1 | 1 | 1 | 1 | 0 | 1 | 1 | 0 | 1 |
| 12 | 1 | 1 | 1 | 0 | 1 | 1 | 1 | 0 | 0 | 1 | 0 | 1 | 1 |
| 13 | 1 | 0 | 0 | 1 | 1 | 1 | 0 | 0 | 1 | 0 | 0 | 1 | 1 |
| 14 | 1 | 1 | 0 | 1 | 1 | 1 | 1 | 1 | 0 | 0 | 0 | 0 | 0 |
| 15 | 1 | 0 | 0 | 0 | 0 | 1 | 1 | 0 | 0 | 0 | 0 | 0 | 0 |
| 16 | 1 | 1 | 0 | 0 | 0 | 0 | 0 | 0 | 0 | 1 | 1 | 1 | 0 |
| 17 | 1 | 1 | 1 | 0 | 0 | 0 | 0 | 0 | 0 | 1 | 1 | 1 | 0 |
| 18 | 1 | 0 | 0 | 1 | 0 | 0 | 1 | 0 | 1 | 1 | 1 | 1 | 1 |
| 19 | 1 | 0 | 1 | 1 | 0 | 0 | 0 | 0 | 1 | 0 | 1 | 1 | 1 |

Performance variation of the resultant code matrix shown in Table 10 will hereinafter be described with reference to FIG. 18.

Referring to FIG. 18, when a row is cyclically shifted upward by a value of 4, it can be easily recognized that uniform performance appears in all information bits. Therefore, when considering uniform performance of the entire input information bits in association with the bit size of CQI data, performance improvement can be achieved using the resultant code matrix obtained when a row is cyclically shifted upward by a value of 4.

In this case, the 10 upper rows of the resultant code matrix can be replaced with the 10 lower rows thereof. The same-value cyclic shift or a different-value cyclic shift can be applied to the ten upper rows and the ten lower rows.

Alternatively, the positions of columns of the (20,A) code matrix can be exchanged with each other. A method for cyclically shifting the generated resultant code within a group of the same-order columns, or a method for exchanging each column with another column within a group of the same-order columns can be applied.

Meanwhile, the resultant code matrix obtained when a row of the (20,A) code matrix is cyclically shifted upward by a value of 5 is shown in Table 11. In this case, the resultant code matrix is equal to a code matrix obtained when a row of the (20,A) code matrix is cyclically shifted downward by a value of 15. In addition, the resultant code matrix is equal to a code matrix obtained when a row of the (20,A) code matrix is cyclically shifted upward by a value of 15, or is also equal to a code matrix obtained when a row of the (20,A) code matrix is cyclically shifted downward by a value of 5.

[Table 11]

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ | $M_{i,11}$ | $M_{i,12}$ |
|---|---|---|---|---|---|---|---|---|---|---|---|---|---|
| 0 | 1 | 1 | 0 | 0 | 1 | 0 | 1 | 1 | 1 | 0 | 1 | 1 | 1 |
| 1 | 1 | 0 | 1 | 0 | 1 | 0 | 1 | 0 | 1 | 1 | 1 | 1 | 1 |
| 2 | 1 | 0 | 0 | 1 | 1 | 0 | 0 | 1 | 1 | 0 | 1 | 1 | 1 |
| 3 | 1 | 1 | 0 | 1 | 1 | 0 | 0 | 1 | 0 | 1 | 1 | 1 | 1 |
| 4 | 1 | 0 | 1 | 1 | 1 | 0 | 1 | 0 | 0 | 1 | 1 | 1 | 1 |
| 5 | 1 | 0 | 1 | 0 | 0 | 1 | 1 | 1 | 0 | 1 | 1 | 1 | 1 |
| 6 | 1 | 1 | 1 | 0 | 0 | 1 | 1 | 0 | 1 | 0 | 1 | 1 | 1 |
| 7 | 1 | 0 | 0 | 1 | 0 | 1 | 0 | 1 | 1 | 1 | 1 | 1 | 1 |
| 8 | 1 | 1 | 0 | 1 | 0 | 1 | 0 | 1 | 0 | 1 | 1 | 1 | 1 |
| 9 | 1 | 0 | 0 | 0 | 1 | 1 | 0 | 1 | 0 | 0 | 1 | 0 | 1 |
| 10 | 1 | 1 | 0 | 0 | 1 | 1 | 1 | 1 | 0 | 1 | 1 | 0 | 1 |
| 11 | 1 | 1 | 1 | 0 | 1 | 1 | 1 | 0 | 0 | 1 | 0 | 1 | 1 |
| 12 | 1 | 0 | 0 | 1 | 1 | 1 | 0 | 0 | 1 | 0 | 0 | 1 | 1 |
| 13 | 1 | 1 | 0 | 1 | 1 | 1 | 1 | 1 | 0 | 0 | 0 | 0 | 0 |

(continued)

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ | $M_{i,11}$ | $M_{i,12}$ |
|---|---|---|---|---|---|---|---|---|---|---|---|---|---|
| 14 | 1 | 0 | 0 | 0 | 0 | 1 | 1 | 0 | 0 | 0 | 0 | 0 | 0 |
| 15 | 1 | 1 | 0 | 0 | 0 | 0 | 0 | 0 | 0 | 0 | 1 | 1 | 0 |
| 16 | 1 | 1 | 1 | 0 | 0 | 4 | 0 | 0 | 0 | 1 | 1 | 1 | 0 |
| 17 | 1 | 0 | 0 | 1 | 0 | 0 | 1 | 0 | 1 | 1 | 1 | 1 | 1 |
| 19 | 1 | 0 | 1 | 1 | 0 | 0 | 0 | 0 | 1 | 0 | 1 | 1 | 1 |
| 19 | 1 | 1 | 1 | 1 | 0 | 0 | 0 | 1 | 0 | 0 | 1 | 1 | 1 |

Performance variation of the resultant code matrix shown in Table 11 will hereinafter be described with reference to FIG. 18.

Referring to FIG. 18, when a row is cyclically shifted upward by a value of 5, it can be easily recognized that superior performance is achieved when input information is 3 bits long. Therefore, when considering the information size of 3 bits in association with the bit size of CQI data, performance improvement can be achieved using the resultant code matrix obtained when a row is cyclically shifted upward by a value of 5.

In this case, the 10 upper rows of the resultant code matrix can be replaced with the 10 lower rows thereof. The same-value cyclic shift or a different-value cyclic shift can be applied to the ten upper rows and the ten lower rows.

Alternatively, the positions of columns of the (20,A) code matrix can be exchanged with each other. A method for cyclically shifting the generated resultant code within a group of the same-order columns, or a method for exchanging each column with another column within a group of the same-order columns can be applied.

Meanwhile, the resultant code matrix obtained when a row of the (20,A) code matrix is cyclically shifted upward by a value of 6 is shown in Table 12. In this case, the resultant code matrix is equal to a code matrix obtained when a row of the (20,A) code matrix is cyclically shifted downward by a value of 14. In addition, the resultant code matrix is equal to a code matrix obtained when a row of the (20,A) code matrix is cyclically shifted upward by a value of 16, or is also equal to a code matrix obtained when a row of the (20,A) code matrix is cyclically shifted downward by a value of 4.

[Table 12]

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ | $M_{i,11}$ | $M_{i,12}$ |
|---|---|---|---|---|---|---|---|---|---|---|---|---|---|
| 0 | 1 | 0 | 1 | 0 | 1 | 0 | 1 | 0 | 1 | 1 | 1 | 1 | 1 |
| 1 | 1 | 0 | 0 | 1 | 1 | 0 | 0 | 1 | 1 | 0 | 1 | 1 | 1 |
| 2 | 1 | 1 | 0 | 1 | 1 | 0 | 0 | 1 | 0 | 1 | 1 | 1 | 1 |
| 3 | 1 | 0 | 1 | 1 | 1 | 0 | 1 | 0 | 0 | 1 | 1 | 1 | 1 |
| 4 | 1 | 0 | 1 | 0 | 0 | 1 | 1 | 1 | 0 | 1 | 1 | 1 | 1 |
| 5 | 1 | 1 | 1 | 0 | 0 | 1 | 1 | 0 | 1 | 0 | 1 | 1 | 1 |
| 6 | 1 | 0 | 0 | 1 | 0 | 1 | 0 | 1 | 1 | 1 | 1 | 1 | 1 |
| 7 | 1 | 1 | 0 | 1 | 0 | 1 | 0 | 1 | 0 | 1 | 1 | 1 | 1 |
| 8 | 1 | 0 | 0 | 0 | 1 | 1 | 0 | 1 | 0 | 0 | 1 | 0 | 1 |
| 9 | 1 | 1 | 0 | 0 | 1 | 1 | 1 | 1 | 0 | 1 | 1 | 0 | 1 |
| 10 | 1 | 1 | 1 | 0 | 1 | 1 | 1 | 0 | 0 | 1 | 0 | 1 | 1 |
| 11 | 1 | 0 | 0 | 1 | 1 | 1 | 0 | 0 | 1 | 0 | 0 | 1 | 1 |
| 12 | 1 | 1 | 0 | 1 | 1 | 1 | 1 | 1 | 0 | 0 | 0 | 0 | 0 |
| 13 | 1 | 0 | 0 | 0 | 0 | 1 | 1 | 0 | 0 | 0 | 0 | 0 | 0 |
| 14 | 1 | 1 | 0 | 0 | 0 | 0 | 0 | 0 | 0 | 0 | 1 | 1 | 0 |
| 15 | 1 | 1 | 1 | 0 | 0 | 0 | 0 | 0 | 0 | 1 | 1 | 1 | 0 |
| 16 | 1 | 0 | 0 | 1 | 0 | 0 | 1 | 0 | 1 | 1 | 1 | 1 | 1 |

18

(continued)

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ | $M_{i,11}$ | $M_{i,12}$ |
|---|---|---|---|---|---|---|---|---|---|---|---|---|---|
| 17 | 1 | 0 | 1 | 1 | 0 | 0 | 0 | 0 | 1 | 0 | 1 | 1 | 1 |
| 18 | 1 | 1 | 1 | 1 | 0 | 0 | 0 | 1 | 0 | 0 | 1 | 1 | 1 |
| 19 | 1 | 1 | 0 | 0 | 1 | 0 | 1 | 1 | 1 | 0 | 1 | 1 | 1 |

Performance variation of the resultant code matrix shown in Table 12 will hereinafter be described with reference to FIG. 18.

Referring to FIG. 18, when a row is cyclically shifted upward by a value of 5, it can be easily recognized that superior performance is achieved when input information is 13 bits long. Therefore, when considering the information size of 13 bits in association with the bit size of CQI data, performance improvement can be achieved using the resultant code matrix obtained when a row is cyclically shifted upward by a value of 6.

In this case, the 10 upper rows of the resultant code matrix can be replaced with the 10 lower rows thereof. The same-value cyclic shift or a different-value cyclic shift can be applied to the ten upper rows and the ten lower rows.

Alternatively, the positions of columns of the (20,A) code matrix can be exchanged with each other. A method for cyclically shifting the generated resultant code within a group of the same-order columns, or a method for exchanging each column with another column within a group of the same-order columns can be applied.

Meanwhile, the resultant code matrix obtained when a row of the (20,A) code matrix is cyclically shifted upward by a value of 7 is shown in Table 13. In this case, the resultant code matrix is equal to a code matrix obtained when a row of the (20,A) code matrix is cyclically shifted downward by a value of 13. In addition, the resultant code matrix is equal to a code matrix obtained when a row of the (20,A) code matrix is cyclically shifted upward by a value of 17, or is also equal to a code matrix obtained when a row of the (20,A) code matrix is cyclically shifted downward by a value of 3.

[Table 13]

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ | $M_{i,11}$ | $M_{i,12}$ |
|---|---|---|---|---|---|---|---|---|---|---|---|---|---|
| 0 | 1 | 0 | 0 | 1 | 1 | 0 | 0 | 1 | 1 | 0 | 1 | 1 | 1 |
| 1 | 1 | 1 | 0 | 1 | 1 | 0 | 0 | 1 | 0 | 1 | 1 | 1 | 1 |
| 2 | 1 | 0 | 1 | 1 | 1 | 0 | 1 | 0 | 0 | 1 | 1 | 1 | 1 |
| 3 | 1 | 0 | 1 | 0 | 0 | 1 | 1 | 1 | 0 | 1 | 1 | 1 | 1 |
| 4 | 1 | 1 | 1 | 0 | 0 | 1 | 1 | 0 | 1 | 0 | 1 | 1 | 1 |
| 5 | 1 | 0 | 0 | 1 | 0 | 1 | 0 | 1 | 1 | 1 | 1 | 1 | 1 |
| 6 | 1 | 1 | 0 | 1 | 0 | 1 | 0 | 1 | 0 | 1 | 1 | 1 | 1 |
| 7 | 1 | 0 | 0 | 0 | 1 | 1 | 0 | 1 | 1 | 0 | 1 | 0 | 1 |
| 8 | 1 | 1 | 0 | 0 | 1 | 1 | 1 | 1 | 0 | 1 | 1 | 0 | 1 |
| 9 | 1 | 1 | 1 | 0 | 1 | 1 | 1 | 0 | 0 | 1 | 0 | 1 | 1 |
| 10 | 1 | 0 | 0 | 1 | 1 | 1 | 0 | 0 | 1 | 0 | 0 | 1 | 1 |
| 11 | 1 | 1 | 0 | 1 | 1 | 1 | 1 | 1 | 0 | 0 | 0 | 0 | 0 |
| 12 | 1 | 0 | 0 | 0 | 0 | 1 | 1 | 0 | 0 | 0 | 0 | 0 | 0 |
| 13 | 1 | 1 | 0 | 0 | 0 | 0 | 0 | 0 | 0 | 0 | 1 | 1 | 0 |
| 14 | 1 | 1 | 1 | 0 | 0 | 0 | 0 | 0 | 0 | 1 | 1 | 1 | 0 |
| 15 | 1 | 0 | 0 | 1 | 0 | 0 | 1 | 0 | 1 | 1 | 1 | 1 | 1 |
| 16 | 1 | 0 | 1 | 1 | 0 | 0 | 0 | 0 | 1 | 0 | 1 | 1 | 1 |
| 17 | 1 | 1 | 1 | 1 | 0 | 0 | 0 | 1 | 0 | 0 | 1 | 1 | 1 |
| 18 | 1 | 1 | 0 | 0 | 1 | 0 | 1 | 1 | 1 | 0 | 1 | 1 | 1 |
| 19 | 1 | 0 | 1 | 0 | 1 | 0 | 1 | 0 | 1 | 1 | 1 | 1 | 1 |

Performance variation of the resultant code matrix shown in Table 13 will hereinafter be described with reference to FIG. 18.

Referring to FIG. 18, when a row is cyclically shifted upward by a value of 7, it can be easily recognized that superior performance is achieved when input information is 6 bits long. Therefore, when considering the information size of 6 bits in association with the bit size of CQI data, performance improvement can be achieved using the resultant code matrix obtained when a row is cyclically shifted upward by a value of 7.

In this case, the 10 upper rows of the resultant code matrix can be replaced with the 10 lower rows thereof. The same-value cyclic shift or a different-value cyclic shift can be applied to the ten upper rows and the ten lower rows.

Alternatively, the positions of columns of the (20,A) code matrix can be exchanged with each other. A method for cyclically shifting the generated resultant code within a group of the same-order columns, or a method for exchanging each column with another column within a group of the same-order columns can be applied.

Meanwhile, the resultant code matrix obtained when a row of the (20,A) code matrix is cyclically shifted upward by a value of 8 is shown in Table 14. In this case, the resultant code matrix is equal to a code matrix obtained when a row of the (20,A) code matrix is cyclically shifted downward by a value of 12. In addition, the resultant code matrix is equal to a code matrix obtained when a row of the (20,A) code matrix is cyclically shifted upward by a value of 18, or is also equal to a code matrix obtained when a row of the (20,A) code matrix is cyclically shifted downward by a value of 2.

[Table 14]

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ | $M_{i,11}$ | $M_{i,12}$ |
|---|---|---|---|---|---|---|---|---|---|---|---|---|---|
| 0 | 1 | 1 | 0 | 1 | 1 | 0 | 0 | 1 | 0 | 1 | 1 | 1 | 1 |
| 1 | 1 | 0 | 1 | 1 | 1 | 0 | 1 | 0 | 0 | 1 | 1 | 1 | 1 |
| 2 | 1 | 0 | 1 | 0 | 0 | 1 | 1 | 1 | 0 | 1 | 1 | 1 | 1 |
| 3 | 1 | 1 | 1 | 0 | 0 | 1 | 1 | 0 | 1 | 0 | 1 | 1 | 1 |
| 4 | 1 | 0 | 0 | 1 | 0 | 1 | 0 | 1 | 1 | 1 | 1 | 1 | 1 |
| 5 | 1 | 1 | 0 | 1 | 0 | 1 | 0 | 1 | 0 | 1 | 1 | 1 | 1 |
| 6 | 1 | 0 | 0 | 0 | 1 | 1 | 0 | 1 | 0 | 0 | 1 | 0 | 1 |
| 7 | 1 | 1 | 0 | 0 | 1 | 1 | 1 | 1 | 0 | 1 | 1 | 0 | 1 |
| 8 | 1 | 1 | 1 | 0 | 1 | 1 | 1 | 0 | 0 | 1 | 0 | 1 | 1 |
| 9 | 1 | 0 | 0 | 1 | 1 | 1 | 0 | 0 | 1 | 0 | 0 | 1 | 1 |
| 10 | 1 | 1 | 0 | 1 | 1 | 1 | 1 | 1 | 0 | 0 | 0 | 0 | 0 |
| 11 | 1 | 0 | 0 | 0 | 0 | 1 | 1 | 0 | 0 | 0 | 0 | 0 | 0 |
| 12 | 1 | 1 | 0 | 0 | 0 | 0 | 0 | 0 | 0 | 0 | 1 | 1 | 0 |
| 13 | 1 | 1 | 1 | 0 | 0 | 0 | 0 | 0 | 0 | 1 | 1 | 1 | 0 |
| 14 | 1 | 0 | 0 | 1 | 0 | 0 | 1 | 0 | 1 | 1 | 1 | 1 | 1 |
| 15 | 1 | 0 | 1 | 1 | 0 | 0 | 0 | 0 | 1 | 0 | 1 | 1 | 1 |
| 16 | 1 | 1 | 1 | 1 | 0 | 0 | 0 | 1 | 0 | 0 | 1 | 1 | 1 |
| 17 | 1 | 1 | 0 | 0 | 1 | 0 | 1 | 1 | 1 | 0 | 1 | 1 | 1 |
| 18 | 1 | 0 | 1 | 0 | 1 | 0 | 1 | 0 | 1 | 1 | 1 | 1 | 1 |
| 19 | 1 | 0 | 0 | 1 | 1 | 0 | 0 | 1 | 1 | 0 | 1 | 1 | 1 |

Performance variation of the resultant code matrix shown in Table 14 will hereinafter be described with reference to FIG. 18.

Referring to FIG. 18, when a row is cyclically shifted upward by a value of 7, it can be easily recognized that superior performance is achieved when input information is 4 bits long. Therefore, when considering the information size of 4 bits in association with the bit size of CQI data, performance improvement can be achieved using the resultant code matrix obtained when a row is cyclically shifted upward by a value of 8.

In this case, the 10 upper rows of the resultant code matrix can be replaced with the 10 lower rows thereof. The same-value cyclic shift or a different-value cyclic shift can be applied to the ten upper rows and the ten lower rows.

Alternatively, the positions of columns of the (20,A) code matrix can be exchanged with each other. A method for cyclically shifting the generated resultant code within a group of the same-order columns, or a method for exchanging each column with another column within a group of the same-order columns can be applied.

Meanwhile, the resultant code matrix obtained when a row of the (20,A) code matrix is cyclically shifted upward by a value of 9 is shown in Table 15. In this case, the resultant code matrix is equal to a code matrix obtained when a row of the (20,A) code matrix is cyclically shifted downward by a value of 11. In addition, the resultant code matrix is equal to a code matrix obtained when a row of the (20,A) code matrix is cyclically shifted upward by a value of 19, or is also equal to a code matrix obtained when a row of the (20,A) code matrix is cyclically shifted downward by a value of 1.

[Table 15]

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ | $M_{i,11}$ | $M_{i,12}$ |
|---|---|---|---|---|---|---|---|---|---|---|---|---|---|
| 0 | 1 | 0 | 1 | 1 | 1 | 0 | 1 | 0 | 0 | 1 | 1 | 1 | 1 |
| 1 | 1 | 0 | 1 | 0 | 0 | 1 | 1 | 1 | 0 | 1 | 1 | 1 | 1 |
| 2 | 1 | 1 | 1 | 0 | 0 | 1 | 1 | 0 | 0 | 0 | 1 | 1 | 1 |
| 3 | 1 | 0 | 0 | 1 | 0 | 1 | 0 | 1 | 1 | 1 | 1 | 1 | 1 |
| 4 | 1 | 1 | 0 | 1 | 0 | 1 | 0 | 1 | 0 | 1 | 1 | 1 | 1 |
| 5 | 1 | 0 | 0 | 0 | 1 | 1 | 0 | 1 | 0 | 0 | 1 | 0 | 1 |
| 6 | 1 | 1 | 0 | 0 | 1 | 1 | 1 | 1 | 0 | 1 | 1 | 0 | 1 |
| 7 | 1 | 1 | 1 | 0 | 1 | 1 | 1 | 0 | 0 | 1 | 0 | 1 | 1 |
| 8 | 1 | 0 | 0 | 1 | 1 | 1 | 0 | 0 | 1 | 0 | 0 | 1 | 1 |
| 9 | 1 | 1 | 0 | 1 | 1 | 1 | 1 | 1 | 0 | 0 | 0 | 0 | 0 |
| 10 | 1 | 0 | 0 | 0 | 0 | 1 | 1 | 0 | 0 | 0 | 0 | 0 | 0 |
| 11 | 1 | 1 | 0 | 0 | 0 | 0 | 0 | 0 | 0 | 0 | 1 | 1 | 0 |
| 12 | 1 | 1 | 1 | 0 | 0 | 0 | 0 | 0 | 0 | 1 | 1 | 1 | 0 |
| 13 | 1 | 0 | 0 | 1 | 0 | 0 | 1 | 0 | 1 | 1 | 1 | 1 | 1 |
| 14 | 1 | 0 | 1 | 1 | 0 | 0 | 0 | 0 | 1 | 0 | 1 | 1 | 1 |
| 15 | 1 | 1 | 1 | 1 | 0 | 0 | 0 | 1 | 0 | 0 | 1 | 1 | 1 |
| 16 | 1 | 1 | 0 | 0 | 1 | 0 | 1 | 1 | 1 | 0 | 1 | 1 | 1 |
| 17 | 1 | 0 | 1 | 0 | 1 | 0 | 1 | 0 | 1 | 1 | 1 | 1 | 1 |
| 18 | 1 | 0 | 0 | 1 | 1 | 0 | 0 | 0 | 1 | 0 | 1 | 1 | 1 |
| 19 | 1 | 1 | 0 | 1 | 1 | 0 | 0 | 1 | 0 | 1 | 1 | 1 | 1 |

Performance variation of the resultant code matrix shown in Table 15 will hereinafter be described with reference to FIG. 18.

Referring to FIG. 18, when a row is cyclically shifted upward by a value of 9, it can be easily recognized that superior performance is achieved when input information is 4 bits long. Therefore, when considering uniform performance of the entire input information bits in association with the bit size of CQI data, performance improvement can be achieved using the resultant code matrix obtained when a row is cyclically shifted upward by a value of 9.

In this case, the 10 upper rows of the resultant code matrix can be replaced with the 10 lower rows thereof. The same-value cyclic shift or a different-value cyclic shift can be applied to the ten upper rows and the ten lower rows.

Alternatively, the positions of columns of the (20,A) code matrix can be exchanged with each other. A method for cyclically shifting the generated resultant code within a group of the same-order columns, or a method for exchanging each column with another column within a group of the same-order columns can be applied.

**<Second Embodiment - Method for generating new code matrix by shifting at least one column from among columns of the code matrix to a predetermined position>**

In accordance with another embodiment of the present invention, a column causing performance deterioration is located at another position so that a new code matrix can be generated.

A representative column causing performance deterioration in the (20,A) code matrix is the 6th column $M_{i,5}$, the position of the column $M_{i,5}$ is changed to a predetermined position such that a new code matrix can be generated. In this case, the newly arranged position may be arbitrarily designated without limitation.

A method for generating a new code matrix by changing the current position of the column $M_{i,5}$ to the position of the last column will hereinafter be described with reference to the attached drawings.

Table 16 shows a new code matrix obtained when the column $M_{i,5}$ is located at the last column.

[Table 16]

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ | $M_{i,11}$ | $M_{i,12}$ |
|---|---|---|---|---|---|---|---|---|---|---|---|---|---|
| 0 | 1 | 1 | 0 | 0 | 0 | 0 | 0 | 0 | 0 | 1 | 1 | 0 | 0 |
| 1 | 1 | 1 | 1 | 0 | 0 | 0 | 0 | 0 | 1 | 1 | 1 | 0 | 0 |
| 2 | 1 | 0 | 0 | 1 | 0 | 1 | 0 | 1 | 1 | 1 | 1 | 1 | 0 |
| 3 | 1 | 0 | 1 | 1 | 0 | 0 | 0 | 1 | 0 | 1 | 1 | 1 | 0 |
| 4 | 1 | 1 | 1 | 1 | 0 | 0 | 1 | 0 | 0 | 1 | 1 | 1 | 0 |
| 5 | 1 | 1 | 0 | 0 | 1 | 1 | 1 | 1 | 0 | 1 | 1 | 1 | 0 |
| 6 | 1 | 0 | 1 | 0 | 1 | 1 | 0 | 1 | 1 | 1 | 1 | 1 | 0 |
| 7 | 1 | 0 | 0 | 1 | 1 | 0 | 1 | 1 | 0 | 1 | 1 | 1 | 0 |
| 8 | 1 | 1 | 0 | 1 | 1 | 0 | 1 | 0 | 1 | 1 | 1 | 1 | 0 |
| 9 | 1 | 0 | 1 | 1 | 1 | 1 | 0 | 0 | 1 | 1 | 1 | 1 | 0 |
| 10 | 1 | 0 | 1 | 0 | 0 | 1 | 1 | 0 | 1 | 1 | 1 | 1 | 1 |
| 11 | 1 | 1 | 1 | 0 | 0 | 1 | 0 | 1 | 0 | 1 | 1 | 1 | 1 |
| 12 | 1 | 0 | 0 | 1 | 0 | 0 | 1 | 1 | 1 | 1 | 1 | 1 | 1 |
| 13 | 1 | 1 | 0 | 1 | 0 | 0 | 1 | 0 | 1 | 1 | 1 | 1 | 1 |
| 14 | 1 | 0 | 0 | 0 | 1 | 0 | 1 | 0 | 0 | 1 | 0 | 1 | 1 |
| 15 | 1 | 1 | 0 | 0 | 1 | 1 | 1 | 0 | 1 | 1 | 0 | 1 | 1 |
| 16 | 1 | 1 | 1 | 0 | 1 | 1 | 0 | 0 | 1 | 0 | 1 | 1 | 1 |
| 17 | 1 | 0 | 0 | 1 | 1 | 0 | 0 | 1 | 0 | 0 | 1 | 1 | 1 |
| 18 | 1 | 1 | 0 | 1 | 1 | 1 | 1 | 0 | 0 | 0 | 0 | 0 | 1 |
| 19 | 1 | 0 | 0 | 0 | 0 | 1 | 0 | 0 | 0 | 0 | 0 | 0 | 1 |

When using the code matrix of Table 16, in so far as the size of input information is not greater than 12 bits, performance deterioration is not generated from the legacy column $M_{i,5}$, the position of which was changed to the position of the last column.

In this case, the 10 upper rows of the resultant code matrix can be replaced with the 10 lower rows thereof. The same-value cyclic shift or a different-value cyclic shift can be applied to the ten upper rows and the ten lower rows.

Alternatively, the positions of columns of the (20,A) code matrix can be exchanged with each other. A method for cyclically shifting the generated resultant code within a group of the same-order columns, or a method for exchanging each column with another column within a group of the same-order columns can be applied.

<Third Embodiment>

In accordance with another embodiment of the present invention, a column causing performance deterioration is cyclically shifted, and the cyclically shifted column is located at another place in such a manner that a new code matrix can be generated,

In this case, since the size of information size can be considered, there is no influence upon the generated channel code, resulting in an increase in performance.

In addition, in accordance with another embodiment of the present invention, a method for deleting a column causing performance deterioration can be used.

That is, when generating a new code matrix by deleting the 6<sup>th</sup> column $M_{i,5}$ causing performance deterioration from the (20,A) code matrix, performance improvement can be achieved.

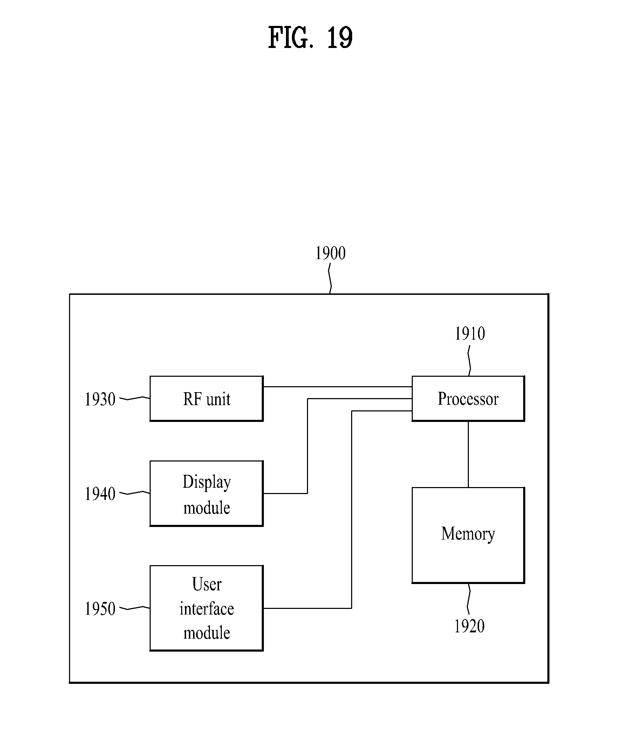

FIG. 19 is a block diagram illustrating a communication device according to embodiments of the present invention.

Referring to FIG. 19, the communication device 1900 includes a processor 1910, a memory 1920, a radio frequency (RF) module 1930, a display module 1940, and a user interface (UI) module 1950.

Some modules of the communication deice 1900 may be omitted for convenience of description and better understanding of the present invention. The communication device 1900 may further include a necessary module. In addition, some modules of the communication device 1900 may be classified into more detailed modules. The processor 1910 may perform a variety of operations required for the embodiments of the present invention with reference to FIG. 19. In more detail, detailed operations of the processor 1920 may refer to contents of FIGS. 1 to 20.

The memory 1920 is connected to the processor 1910, and stores an operating system, an application, program code, data and the like. The RF module 1930 is connected to the processor 1910, converts a baseband signal into a radio frequency (RF) signal, or converts the RF signal into the baseband signal. For these operations, the RF module 1930 performs analog conversion, amplification, filtering, and frequency up-conversion in order or performs such operations in reverse order. The display module 1940 is connected to the processor 1910 and displays a variety of information. The scope or spirit of the display module 1940 of the present invention is not limited thereto, and the display module 1940 may be any of well-known elements, for example, a Liquid Crystal Display (LCD), a Light Emitting Diode (LED), an Organic Light Emitting Diode (OLED) and the like. The user interface (UI) module 1950 is connected to the processor 1910, and may be implemented as a combination of user interfaces such as a keypad, a touchscreen, etc.

The aforementioned embodiments are achieved by combination of structural elements and features of the present invention in a predetermined fashion. Each of the structural elements or features should be considered selectively unless specified otherwise. Each of the structural elements or features may be carried out without being combined with other structural elements or features. Also, some structural elements and/or features may be combined with one another to constitute the embodiments of the present invention. The order of operations described in the embodiments of the present invention may be changed. Some structural elements or features of one embodiment may be included in another embodiment, or may be replaced with corresponding structural elements or features of another embodiment. Moreover, it will be apparent that some claims referring to specific claims may be combined with other claims referring to claims other than the specific claims to constitute the embodiment or add new claims by means of amendment after the application is filed.

The above-mentioned embodiments of the present invention have been disclosed on the basis of a data communication relationship between a base station and a terminal. Specific operations to be conducted by the base station in the present invention may also be conducted by an upper node of the base station as necessary. In other words, it will be obvious to those skilled in the art that various operations for enabling the base station to communicate with a terminal in a network composed of several network nodes including the base station will be conducted by the base station or other network nodes other than the base station. The term 'Base Station' may be replaced with the term 'fixed station', 'Node-B', 'eNode-B (eNB)', or access point as necessary. The term 'terminal' may be replaced with the term 'user equipment (UE)', 'mobile station (MS)' or 'mobile subscriber station (MSS)' as necessary.

The embodiments of the present invention may be achieved by various means, for example, hardware, firmware, software, or a combination thereof. In a hardware configuration, the embodiments of the present invention may be implemented by one or more application specific integrated circuits (ASICs), digital signal processors (DSPs), digital signal processing devices (DSPDs), programmable logic devices (PLDs), field programmable gate arrays (FPGAs), processors, controllers, microcontrollers, microprocessors, etc.

In a firmware or software configuration, the embodiments of the present invention may be achieved by a module, a procedure, a function, etc. performing the above-described functions or operations. Software code may be stored in a memory unit and driven by a processor. The memory unit is located at the interior or exterior of the processor and may transmit data to and receive data from the processor via various known means.

It will be apparent to those skilled in the art that various modifications and variations can be made in the present invention without departing from the spirit or scope of the invention. Therefore, the above-mentioned detailed description must be considered only for illustrative purposes instead of restrictive purposes. The scope of the present invention must be decided by a rational analysis of the claims, and all modifications within equivalent ranges of the present invention are within the scope of the present invention.

[Industrial Applicability]

As is apparent from the above description, the embodiments of the present invention can be applied to a wireless communication system. In more detail, the embodiments of the present invention can be applied to a wireless communication system for use in a cellular system.

**Claims**

1. A method for allowing a user equipment (UE) to transmit channel quality information (CQI) data using a code matrix to which a Reed-Muller (RM) coding scheme is applied in a wireless communication system, the method comprising:

generating a first code matrix by cyclically shifting a row of the code matrix by a predetermined column-directional size;
encoding the CQI data by applying the first code matrix to the CQI data; and
transmitting the encoded CQI data.

2. The method according to claim 1, further comprising:

if a bit size of the CQI data is equal to or exceeds a predetermined number, generating the first code matrix.

3. The method according to claim 2, wherein:

if the number of rows of the code matrix is set to 20, the predetermined number is set to 6.

4. The method according to claim 1, wherein:

if the number of rows of the code matrix is set to 20, the predetermined column-directional size is set to any one of 1 to 9.

5. The method according to claim 1, wherein:

the number of rows of the code matrix $M_{i,n}$ is denoted by $B$, and the encoded CQI data $b_i$ is generated according to the following equation using the CQI data $a_n$ and the first code matrix $M_{i,n}$:

[Equation]

$$b_i = \sum_{n=0}^{A-1} \left( a_n \cdot M_{i,n}' \right) \bmod 2$$

where A is a bit size of the CQI data, $i'$ is denoted by $i' = (i+k) \bmod B$, $i$ is a row index, $k$ is any one of integers ranging from 1 to 2 , and $n$ is a column index.

6. The method according to claim 5, wherein the number of rows B is set to 18 or 20.

7. A method for allowing a user equipment (UE) to transmit channel quality information (CQI) data using at least one code matrix to which a Reed-Muller (RM) coding scheme is applied in a wireless communication system, the method comprising:

generating a second code matrix by shifting a first row corresponding to at least one row of the code matrix to a predetermined position;
encoding the CQI data by applying the second code matrix to the CQI data; and
transmitting the encoded CQI data.

8. The method according to claim 7, wherein the predetermined position corresponds to the last column of the code matrix.

9. A user equipment (UE) for transmitting channel quality information (CQI) data using a code matrix to which a Reed-Muller (RM) coding scheme is applied in a wireless communication system, the user equipment (UE) comprising:

a processor configured to generate a first code matrix by cyclically shifting a row of the code matrix by a predetermined column-directional size, and encode the CQI data by applying the first code matrix to the CQI data; and
a transmission module configured to transmit the encoded CQI data.

**10.** The user equipment (UE) according to claim 9, wherein the processor is configured to, if a bit size of the CQI data is equal to or exceeds a predetermined number, generate the first code matrix.

**11.** The user equipment (UE) according to claim 10, wherein:

if the number of rows of the code matrix is set to 20, the predetermined number is set to 6.

**12.** The user equipment (UE) according to claim 9, wherein:

if the number of rows of the code matrix is set to 20, the predetermined column-directional size is set to any one of 1 to 9.

**13.** The user equipment (UE) according to claim 9, wherein:

the number of rows of the code matrix $M_{i,n}$ is denoted by $B$, and the processor is configured to generate the encoded CQI data $b_i$ according to the following equation using the CQI data $a_n$ and the first code matrix $M_{i,n}$:

[Equation]

$$b_i = \sum_{n=0}^{A-1} \left( a_n \cdot M_{i,n} \right) \mathrm{mod} \quad 2$$

where A is a bit size of the CQI data, $\dot{i}$ is denoted by $\dot{i}=(i+k)\mathrm{mod}B$, $i$ is a row index, $k$ is any one of integers ranging from 1 to $\dfrac{B}{2}-1$, and $n$ is a column index.

**14.** The method according to claim 13, wherein the number of rows B is set to 18 or 20.

**15.** A user equipment (UE) for transmitting channel quality information (CQI) data using at least one code matrix to which a Reed-Muller (RM) coding scheme is applied in a wireless communication system, the user equipment (UE) comprising:

a processor configured to generate a second code matrix by shifting a first row corresponding to at least one row of the code matrix to a predetermined position, and encoding the CQI data by applying the second code matrix to the CQI data; and
a transmission module configured to transmit the encoded CQI data.

**16.** The user equipment (UE) according to claim 15, wherein the predetermined position corresponds to the last column of the code matrix.

# FIG. 1

EP 2 579 532 A2

Initial cell search — System information reception — Random access procedure — General DL/UL Tx/Rx S108

| P/S - SCH & [DLRS] & PBCH | PDCCH/ PDSCH (BCCH) | PRACH | PDCCH/ PDSCH | PRACH | PDCCH/ PDSCH | PDCCH/ PDSCH | PUSCH PUCCH |

S101    S102    S103    S104    S105    S106    S107

• DL/UL ACK/NACK
• report UE CQI/PMI/rank
  using PUSCH and PUCCH

FIG. 2

## FIG. 3

# FIG. 4

EP 2 579 532 A2

- CP: Cyclic Prefix
- PS: Pulse Shaping
- M > N

Subcarrier mapping

$\{x_0, x_1 \ldots, x_{N-1}\}$
One block

410 — Serial-to-parallel converter

402 — N-point DFT module → $\{X_k\}$

403 — Subcarrier (0 to M-1)

$\{\tilde{x}_t\}$

404 — M-point IDFT module → $\{\tilde{x}_m\}$

405 — Parallel-to-serial converter

406 — CP attachment

$\{\tilde{x}_0, \tilde{x}_1 \ldots, \tilde{x}_{M-1}\}$
One block

SC - FDMA: ☐ + ▨

OFDMA: ☐

# FIG. 5

(a)

(b)

FIG. 6

EP 2 579 532 A2

# FIG. 7

One component carrier
(e.g., 20MHz BW chunk)

One component carrier #1
(e.g., 20MHz BW chunk)

ex.) Localized mapping
in one subblock

frequency-
domain mapping

Modulated symbol → DFT → DFT output

Subblock #0
Subblock #1
Subblock #2
Subblock #3

Subblock #0
Subblock #1
Subblock #2
Subblock #Nsb-1

IFFT

Cluster-DFT scheme

One component carrier
#Nsb-1 (e.g., 20MHz BW chunk)

EP 2 579 532 A2

# FIG. 8

Modulated symbol → DFT → DFT output → Cluster-DFT scheme

Subblock #0, Subblock #1, Subblock #2, Subblock #3

frequency-domain mapping

ex.) Localized mapping in one subblock

Subblock #0 → IFFT → $\exp(2*pi*f\_0*t)$ → One component carrier #0 (e.g., 20MHz BW chunk)

Subblock #1 → IFFT → $\exp(2*pi*f\_1*t)$ → One component carrier #1 (e.g., 20MHz BW chunk)

Subblock #2 → IFFT → $\exp(2*pi*f\_2*t)$

Subblock #Nsb-1 → IFFT → $\exp(2*pi*f\_Nsb-1)*t)$ → One component carrier #Nsb-1 (e.g., 20MHz BW chunk)

FIG. 9

EP 2 579 532 A2

# FIG. 10

```
        S11                    S12               S13              S14
         |                      |                 |                |
   ┌─────────────┐      ┌─────────────────┐   ┌──────┐    ┌──────────────┐
   │ Generate RS │ ───► │ Localized mapping│──►│ IFFT │──► │ CP attachment│
   └─────────────┘      └─────────────────┘   └──────┘    └──────────────┘
```

# FIG. 11

In case of normal CP

One SC-FDMA symbol

One slot

One subframe

RS

# FIG. 12

In case of extended CP

One SC-FDMA symbol

One slot

One subframe

RS

# FIG. 13

$a_0, a_1 ...., a_{A-1}$

CRC attachment
for TB — 130

$b_0, b_1 ...., b_{B-1}$

CRC attachment for code block — 131

$c_{r0}, c_{r1}, ...., c_{r(K-1)}$

Channel coding — 132

$d_{r0}^{(i)}, d_{r1}^{(i)}, ..., d_{r(D_r-1)}^{(i)}$

Rate matching — 133

$o_0, o_1, ..., o_{Q-1}$ $[o_0^{RI}]$ or $[o_0^{RI} o_1^{RI}]$ $[o_0^{ACK}]$ or $[o_0^{ACK} o_1^{ACK}]$ or

$e_{r0}, e_{r1}, ..., e_{r(E_r-1)}$   134   136   137   $[o_0^{ACK} o_1^{ACK} ... o_{0\,ACK-1}^{ACK}]$

138

Code block
combination     Channel
coding     Channel
coding     Channel
coding

$f_0, f_1, ..., f_{G-1}$   135   $q_0, q_1, ..., q_{Qcqi-1}$ $q_0^{RI}, q_1^{RI}, ..., q_{Q_{RI}-1}^{RI}$ $q_0^{ACK}, q_1^{ACK}, ..., q_{Q_{ACK}-1}^{ACK}$

Multiplex data/control information

$g_0, g_1, ..., g_{H-1}$

Channel interleaver — 139

$h_0, h_1, ..., h_{H+Q_{RI}-1}$

# FIG. 14

# FIG. 15

```
        ┌─────────────────────────────────────────────┐
        │  Recognize rank of data for uplink shared channel  │ ──── S150
        └─────────────────────────────────────────────┘
                              │
                              ▼
        ┌─────────────────────────────────────────────┐
        │  Establish rank of uplink control information to be  │ ──── S151
        │  identical to rank of data for uplink shared channel │
        └─────────────────────────────────────────────┘
                              │
                              ▼
        ┌─────────────────────────────────────────────┐
        │       Multiplex first control information from       │ ──── S152
        │         among data and control information          │
        └─────────────────────────────────────────────┘
                              │
                              ▼
        ┌─────────────────────────────────────────────┐
        │  Perform channel interleaving with the remaining control │ ──── S153
        │  information other than first control information from    │
        │  among multiplexed output and the control information    │
        └─────────────────────────────────────────────┘
                              │
                              ▼
        ┌─────────────────────────────────────────────┐
        │        Modulate channel interleaved output          │ ──── S154
        └─────────────────────────────────────────────┘
                              │
                              ▼
```

FIG. 16

Data information bit [a_0,a_1...,a_N0-1] codeword#0 → Channel coding (TBCC or turbo code) (160) → Encoded data bit [f_0,f_1...,f_Nc0-1] (160) → Rate matching (161) → Rate-matched data bit [k_0,k_1...,k_Ndata0-1] (161) → Scrambling (162) → Codeword-layer mapping (including layer shifting or permutation) (163)

Data information bit [b_0,b_1...,b_N1-1] codeword#1 → Channel coding (TBCC or turbo code) (160) → Encoded data bit [g_0,g_1...,g_Nc1-1] (160) → Rate matching (161) → Rate-matched data bit [l_0,l_1...,l_Ndata1-1] (161) → Scrambling (162)

Control information bit for CQI [c_0,c_1...,c_Mcqi-1] → Channel coding (165) → Encoded control bit for CQI [h_0,h_1...,h_Mccqi-1] → Bit size control for control channel (e.g., repetition, rate matching etc.) (166) → [m_0,m_1...,m_Ocqi-1] → Scrambling (167)

Control information bit for RI [d_0,d_1...,d_Mri-1] → Channel coding (165) → Encoded control bit for RI [i_0,i_1...,i_Mcri-1] → [n_0,n_1...,n_Ori-1] → Scrambling (167)

Control information bit for ACK/NAK [e_0,e_1...,e_Mack-1] → Channel coding (165) → Encoded control bit for ACK/NACK [j_0,j_1...,j_Mcack-1] → [p_0,p_1...,p_Oack-1] → Scrambling (167)

Data/control information multiplexing (164) → Channel interleaver (168), layers 0 ... N_layer-1

Modulation mapper (169) → DFT precoder (170) → MIMO precoding (171) → Resource element mapper (172) → SC-FDMA signal generator (through inverse Fourier transform) (173), 0 ... N_antport-1

## FIG. 17

If initial transmission is greater than 1CW, this is used for 1CW retransmission.

# FIG. 18

# FIG. 19